# EUROPEAN PATENT APPLICATION

(11) **EP 2 546 894 A2**
(43) Date of publication of application: **16.01.2013**
(21) Application number: 12176117.5
(22) Date of filing: 12.07.2012
(51) Int. Cl.: H01L 33/46

(54) **Semiconductor light emitting device**

(30) Priority: 12.07.2011 JP 2011153995
(71) Applicant: Kabushiki Kaisha Toshiba, Tokyo (JP)
(72) Inventor: Shimokawa, Kazuo, Tokyo (JP); Higuchi, Kazuhito, Tokyo (JP); Obata, Susumu, Tokyo (JP)
(74) Representative: HOFFMANN EITLE

(57) **Abstract**

According to one embodiment, a semiconductor light emitting device (110, 110a-110g, 110p, 111a, 111b, 112a, 112b, 120a-120f, 121a, 121b, 122a, 112b) includes a stacked body (15), a first electrode (40), a second electrode (50), a reflective layer (60), a first metal pillar (45), a second metal pillar (55), and a sealing unit (80). The stacked body (15) includes first and second semiconductor layers (10, 20), and a light emitting unit (30). The light emitting unit (30) is provided between the second portion (12) and the second semiconductor layer (20). The first electrode (40) is provided on the first semiconductor layer (10). The second electrode (50) is provided on the second semiconductor layer (20). The reflective layer (60) covers a side surface of the stacked body (15) and insulative and reflective. The first metal pillar (45) is electrically connected to the first electrode (40). The second metal pillar (55) is electrically connected to the second electrode (50). The sealing unit (80) seals the first and second metal pillars (45, 55) to leave end portions of the first and second metal pillars (45, 55) exposed.

## Description

### FIELD

Embodiments described herein relate generally to a semiconductor light emitting device.

### BACKGROUND

For example, semiconductor light emitting devices such as LEDs (Light Emitting Diodes) and the like that use nitride semiconductors are being developed. For example, a semiconductor light emitting device configured to emit white light by combining an LED configured to emit blue light with a fluorescer configured to emit yellowish light by absorbing the blue light also is being developed.

In such a semiconductor light emitting device, it is desirable to increase the luminous efficiency and increase the light extraction efficiency of the light emitted from the light emitting layer. Also, it is desirable to reduce the unevenness of the color of the light that is obtained.

### BRIEF DESCRIPTION OF THE DRAWINGS

FIG. 1A and FIG. 1B are schematic views illustrating the configuration of a semiconductor light emitting device according to a first embodiment;
FIG. 2A and FIG. 2B are schematic views illustrating the configuration of the semiconductor light emitting device according to the first embodiment;
FIG. 3 is a schematic view illustrating the configuration of a portion of the semiconductor light emitting device according to the first embodiment;
FIG. 4A and FIG. 4B are schematic cross-sectional views illustrating the configuration of a portion of the semiconductor light emitting device according to the first embodiment;
FIG. 5 is a schematic cross-sectional view illustrating the configuration of another semiconductor light emitting device according to the first embodiment;
FIG. 6A to FIG. 6D, FIG. 7A to FIG. 7C, and FIG. 8A to FIG. 8C are schematic cross-sectional views in order of the processes, illustrating a method for manufacturing the semiconductor light emitting device according to the first embodiment;
FIG. 9A and FIG. 9B are schematic cross-sectional views illustrating the operation of the semiconductor light emitting device according to the first embodiment;
FIG. 10A to FIG. 10C are schematic cross-sectional views illustrating the configuration and the operation of a semiconductor light emitting device of a first reference example;
FIG. 11A to FIG. 11C are schematic cross-sectional views illustrating the configurations of semiconductor light emitting devices of second to fourth reference examples;
FIG. 12 is a schematic cross-sectional view illustrating the configuration of another semiconductor light emitting device according to the first embodiment;
FIG. 13A and FIG. 13B are schematic cross-sectional views illustrating the configuration of other semiconductor light emitting devices according to the first embodiment;
FIG. 14A and FIG. 14B are schematic cross-sectional views illustrating the configurations of other semiconductor light emitting devices according to the first embodiment;
FIG. 15A and FIG. 15B are schematic cross-sectional views illustrating the configurations of other semiconductor light emitting devices according to the first embodiment;
FIG. 16A and FIG. 16B are schematic cross-sectional views illustrating the configurations of other semiconductor light emitting devices according to the first embodiment;
FIG. 17A and FIG. 17B are schematic cross-sectional views illustrating the configurations of other semiconductor light emitting devices according to the first embodiment;
FIG. 18A to FIG. 18C are schematic cross-sectional views illustrating the configurations of semiconductor light emitting devices according to a second embodiment;
FIG. 19A to FIG. 19C are schematic cross-sectional views illustrating the configurations of other semiconductor light emitting devices according to the second embodiment;
FIG. 20A and FIG. 20B are schematic cross-sectional views illustrating the configurations of other semiconductor light emitting devices according to the second embodiment; and
FIG. 21A and FIG. 21B are schematic cross-sectional views illustrating the configurations of other semiconductor light emitting devices according to the second embodiment.

### DETAILED DESCRIPTION

According to one embodiment, a semiconductor light emitting device includes a stacked body, a first electrode, a second electrode, a reflective layer, a first metal pillar, a second metal pillar, and a sealing unit. The stacked body includes a first semiconductor layer, a second semiconductor layer, and a light emitting unit. The first semiconductor layer has a first portion and a second portion juxtaposed with the first portion, and has a first conductivity type. The second semiconductor layer has a second conductivity type. The light emitting unit is provided between the second portion and the second semiconductor layer. The stacked body has a first major surface on a side of the first semiconductor layer and a second major surface on a side of the second semiconductor layer. The first electrode is provided on a surface of the first portion on a side of the second major surface. The second electrode is provided on a surface of the second semiconductor layer on a side of the second major surface. The reflective layer covers a side surface of the stacked body, is insulative and reflective with respect to an emitted light emitted from the light emitting unit. The first metal pillar extends in a first direction from the first semiconductor layer toward the second semiconductor layer, and is electrically connected to the first electrode. The second metal pillar extends in the first direction, and is electrically connected to the second electrode. The sealing unit seals the first metal pillar and the second metal pillar to leave an end portion of the first metal pillar and an end portion of the second metal pillar exposed.

Various embodiments will be described hereinafter with reference to the accompanying drawings.

The drawings are schematic or conceptual; and the relationships between the thicknesses and the widths of portions, the proportions of sizes between portions, etc., are not necessarily the same as the actual values thereof. Further, the dimensions and/or the proportions may be illustrated differently among the drawings, even for identical portions.

In the specification and the drawings of the application, components similar to those described in regard to a drawing thereinabove are marked with like reference numerals, and a detailed description is omitted as appropriate.

### First embodiment

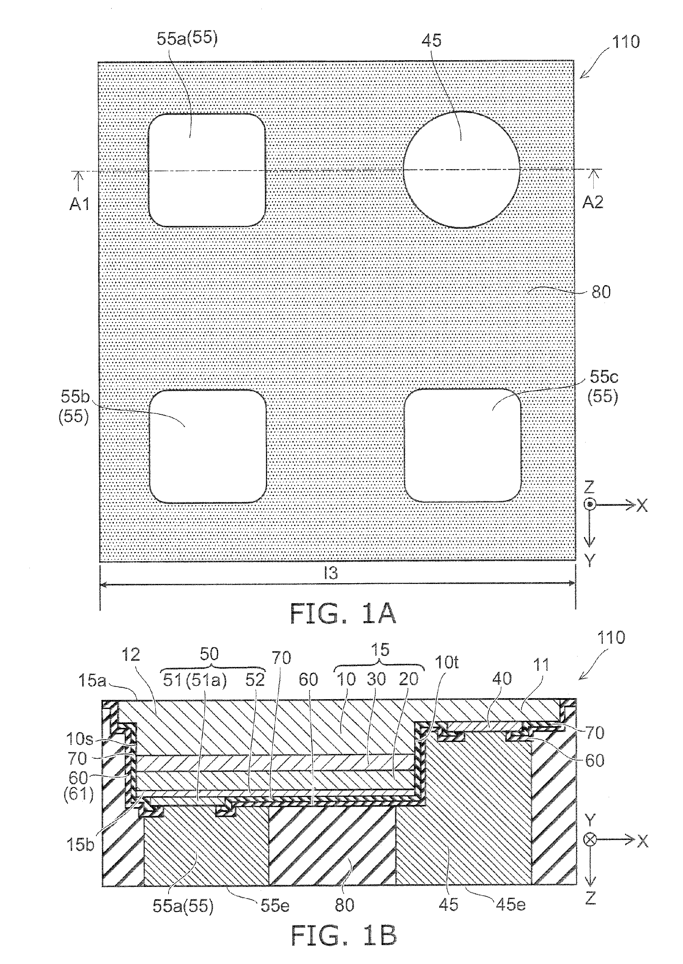

FIG. 1A and FIG. 1B are schematic views illustrating the configuration of a semiconductor light emitting device according to a first embodiment.

Namely, FIG. 1A is a plan view; and FIG. 1B is a cross-sectional view along line A1-A2 of FIG. 1A.

As illustrated in FIG. 1A and FIG. 1B, the semiconductor light emitting device 110 according to the embodiment includes a stacked body 15, a first electrode 40, a second electrode 50, a first metal pillar 45, a second metal pillar 55, and a sealing unit 80.

The stacked body 15 includes a first semiconductor layer 10, a second semiconductor layer 20, and a light emitting unit 30.

The first semiconductor layer 10 has a first portion 11 and a second portion 12. The second portion 12 is juxtaposed with the first portion 11. The first semiconductor layer 10 has the first conductivity type.

The second semiconductor layer 20 has the second conductivity type. The second conductivity type is a conductivity type different from the first conductivity type. For example, the first conductivity type is an n type; and the second conductivity type is a p type. The embodiment is not limited thereto. The first conductivity type may be the p type; and the second conductivity type may be the n type. Hereinbelow, the case is described where the first conductivity type is the n type and the second conductivity type is the p type.

The light emitting unit 30 is provided between the second portion 12 and the second semiconductor layer 20.

The first semiconductor layer 10, the second semiconductor layer 20, and the light emitting unit 30 include, for example, a nitride semiconductor. For example, the first semiconductor layer 10 includes an n-type cladding layer. For example, the second semiconductor layer 20 includes a p-type cladding layer. Examples of the light emitting unit 30 are described below.

The stacked body 15 has a first major surface 15a and a second major surface 15b. The second major surface 15b is a surface on the side opposite to the first major surface 15a. The first major surface 15a is a major surface of the stacked body 15 on the first semiconductor layer 10 side. The second major surface 15b is a major surface of the stacked body 15 on the second semiconductor layer 20 side.

Herein, a direction from the first semiconductor layer 10 toward the second semiconductor layer 20 is taken as a Z-axis direction (the first direction). One axis perpendicular to the Z axis is taken as an X axis (a second axis). An axis perpendicular to the Z axis and the X axis is taken as a Y axis (a third axis). The Z axis (the first axis) is perpendicular to the first major surface 15a and perpendicular to the second major surface 15b.

For example, the first semiconductor layer 10, the light emitting unit 30, and the second semiconductor layer 20 are formed by crystal growth in this order on a substrate to form a stacked crystal film used to form the stacked body 15. Then, a portion of the stacked crystal film is removed from the second major surface 15b side to reach the first semiconductor layer 10. Thereby, a portion (the first portion 11) of the first semiconductor layer 10 is exposed. The light emitting unit 30 and the second semiconductor layer 20 remain on the second portion 12. Thereby, the stacked body 15 is formed. The second portion 12 is juxtaposed with the first portion 11 in the X-Y plane.

As described below, for example, the stacked body 15 is separated from the substrate after the crystal of the stacked body 15 is grown on the substrate.

The first electrode 40 is provided on the surface of the first portion 11 of the first semiconductor layer 10 on the second major surface 15b side. In other words, the first electrode 40 is provided on the exposed portion recited above.

The second electrode 50 is provided on the surface of the second semiconductor layer 20 on the second major surface 15b side. In this example, the second electrode 50 includes a p-side electrode 51 and a p-side conductive layer 52. The p-side conductive layer 52 is provided on the surface of the second semiconductor layer 20 on the second major surface 15b side. A portion of the p-side conductive layer 52 is provided between the p-side electrode 51 and the second semiconductor layer 20.

However, the embodiment is not limited thereto. The p-side conductive layer 52 may not be provided on the second electrode 50. In such a case, the p-side electrode 51 contacts the second semiconductor layer 20.

A reflective layer 60 covers the side surface of the stacked body 15. The side surface of the stacked body 15 includes an outer edge side surface 10s and a boundary side surface 10t. The side surface of the stacked body 15 is described below. The reflective layer 60 is reflective with respect to the emitted light which is emitted from the light emitting unit 30.

The first metal pillar 45 is electrically connected to the first electrode 40. The first metal pillar 45 extends in the Z-axis direction.

The second metal pillar 55 is electrically connected to the second electrode 50. The second metal pillar 55 extends in the Z-axis direction. In this example, three second metal pillars (the second metal pillars 55a, 55b, and 55c) are provided as the second metal pillars 55. However, the embodiment is not limited thereto. The number of the second metal pillars 55 is arbitrary. The number of the first metal pillars 45 also is arbitrary.

The sealing unit 80 seals the first metal pillar 45 and the second metal pillar 55 while leaving an end portion 45e of the first metal pillar 45 and an end portion 55e of the second metal pillar 55 exposed. The end portion 45e of the first metal pillar 45 is the end of the first metal pillar 45 on the side opposite to the first electrode 40. The end portion 55e of the second metal pillar 55 is the end of the second metal pillar 55 on the side opposite to the second electrode 50. In other words, the sealing unit 80 covers the side surface of the first metal pillar 45 and the side surface of the second metal pillar 55. The sealing unit 80 also covers at least a portion of the reflective layer 60.

Thereby, a high efficiency is obtained.

For example, the reflectance of the reflective layer 60 with respect to the emitted light is not less than the reflectance of the sealing unit 80 with respect to the emitted light. In the embodiment as described below, the emitted light which is emitted from the light emitting unit 30 is efficiently reflected by the reflective layer 60 and is efficiently emitted from the first major surface 15a to the outside. Thereby, a high efficiency is obtained.

The reflective characteristics of the sealing unit 80 of the embodiment are arbitrary because the emitted light which is emitted from the light emitting unit 30 is reflected by the reflective layer 60. However, there are cases where the light emitted from the first major surface 15a is reflected by structural bodies provided around the semiconductor light emitting device and returns toward the semiconductor light emitting device 110. At this time, the light is lost in the case where the sealing unit 80 is light-absorbing. Therefore, it is more favorable for the sealing unit 80 to be reflective with respect to the emitted light. For example, according to the configuration of the structural bodies disposed in the semiconductor light emitting device 110, the reflectance of the sealing unit 80 (particularly, the surface of the sealing unit 80) with respect to the emitted light may be set to be higher than the reflectance of the reflective layer 60 with respect to the emitted light.

In this example, the semiconductor light emitting device 110 further includes a foundation insulating layer 70. At least a portion of the foundation insulating layer 70 is provided between the reflective layer 60 and the side surface of the stacked body 15. For example, the foundation insulating layer 70 is transmissive with respect to the emitted light. For example, the reflectance of the foundation insulating layer 70 with respect to the emitted light is lower than the reflectance of the reflective layer 60 with respect to the emitted light. The foundation insulating layer 70 is insulative.

For example, a length 13 of the semiconductor light emitting device 110 along the X axis is about 600 micrometers (µm). For example, the length of the semiconductor light emitting device 110 along the Y axis is the same as the length 13. However, the embodiment is not limited thereto. The dimensions of the semiconductor light emitting device 110 are arbitrary.

In the semiconductor light emitting device 110, the first electrode 40 and the second electrode 50 are provided on the second major surface 15b side; and the emitted light is emitted from the first major surface 15a. For example, the semiconductor light emitting device 110 is a flip chip-type semiconductor light emitting device.

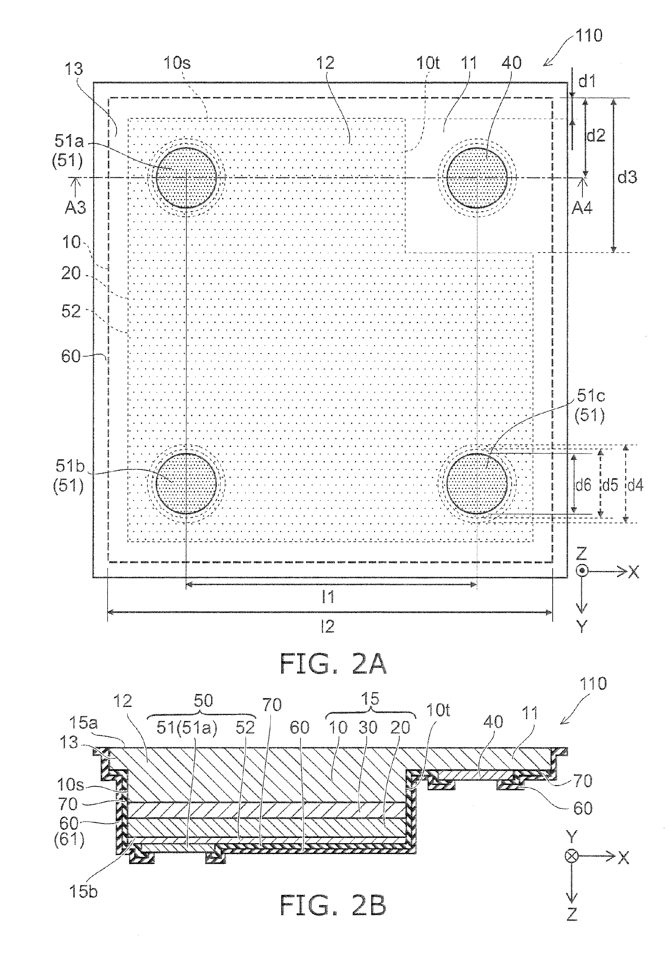

FIG. 2A and FIG. 2B are schematic views illustrating the configuration of the semiconductor light emitting device according to the first embodiment.

These drawings illustrate the configuration of the semiconductor light emitting device 110 in a state in which the first metal pillar 45, the second metal pillar 55, and the sealing unit 80 are removed for better understanding of the configuration. FIG. 2A is a plan view; and FIG. 2B is a cross-sectional view along line A3-A4 of FIG. 2A.

In this example as illustrated in FIG. 2A and FIG. 2B, the second electrode 50 includes three p-side electrodes 51 (the p-side electrodes 51a, 51b, and 51c) and one p-side conductive layer 52. The p-side electrodes 51a, 51b, and 51c are electrically connected to the p-side conductive layer 52. The p-side electrodes 51a, 51b, and 51c are electrically connected respectively to the second metal pillars 55a, 55b, and 55c recited above.

The stacked body 15 has the outer edge side surface 10s and the boundary side surface 10t. The outer edge side surface 10s is the side surface of the outer edge of the stacked body 15 when the stacked body 15 is viewed in the Z-axis direction. The boundary side surface 10t is the side surface of the stacked body 15 positioned between the first portion 11 and the second portion 12.

In this example, the outer edge of the stacked body 15 is rectangular (e.g., square) when viewed in the Z-axis direction. The outer edge side surface 10s is the side surface of this rectangular outer edge. For example, the boundary side surface 10t is the side surface positioned between the first electrode 40 and the second electrode 50 when viewed in the Z-axis direction.

The reflective layer 60 covers at least a portion of the outer edge side surface 10s and at least a portion of the boundary side surface 10t.

The foundation insulating layer 70 is provided between the reflective layer 60 and the at least a portion of the outer edge side surface 10s recited above. Further, the foundation insulating layer 70 is provided between the reflective layer 60 and the at least a portion of the boundary side surface 10t recited above.

In this example, the foundation insulating layer 70 covers the entire boundary side surface 10t. Thereby, the insulative properties are better for the portion of the stacked body 15 between the first electrode 40 and the second electrode 50 where the current density is particularly high; and, for example, the reliability in particular can be increased.

In this example, a length 12 of the stacked body 15 along the X axis is, for example, about 580 µm. The length of the stacked body 15 along the Y axis is, for example, the same as the length 12.

A distance 11 from the X-axis center of the first electrode 40 to the X-axis center of the p-side electrode 51a is, for example, about 380 µm. The distance from the Y-axis center of the first electrode 40 to the Y-axis center of the p-side electrode 51c is, for example, the same as the distance I1.

In this example, the first portion 11 is provided in one corner of the stacked body 15 when viewed in the Z-axis direction. At the sides communicating with this corner, a distance d1 between the outer edge of the second semiconductor layer 20 and the outer edge of the first semiconductor layer 10 is, for example, about 25 µm. A distance d2 from the Y-axis center of the first electrode 40 to the outer edge of the first semiconductor layer 10 along the Y-axis direction is, for example, about 100 µm. A length d3 of the first portion 11 along the Y-axis direction is, for example, about 200 µm. The length of the first portion 11 along the X-axis direction is, for example, the same as the length d3.

In this example, the configuration of the p-side electrode 51 is a circle when viewed in the Z-axis direction. A diameter d4 of the p-side electrode 51 (the length along the X-axis direction and the length along the Y-axis direction) when viewed in the Z-axis direction is, for example, 100 µm. A diameter d5 (the length along the X-axis direction and the length along the Y-axis direction) of the opening of the foundation insulating layer 70 provided on the p-side electrode 51 is, for example, 90 µm when viewed in the Z-axis direction. A diameter d6 (the length along the X-axis direction and the length along the Y-axis direction) of the opening of the reflective layer 60 provided on the p-side electrode 51 is, for example, 80 µm when viewed in the Z-axis direction.

In the embodiment, the configuration of the p-side electrode 51 when viewed in the Z-axis direction, the configuration of the opening of the foundation insulating layer 70 on the p-side electrode 51 when viewed in the Z-axis direction, and the configuration of the opening of the reflective layer 60 on the p-side electrode 51 when viewed in the Z-axis direction are arbitrary.

The configuration of the first electrode 40 is a circle when viewed in the Z-axis direction. The diameter of the first electrode 40 is the same as the diameter d4 when viewed in the Z-axis direction. The diameter of the opening of the foundation insulating layer 70 provided on the first electrode 40 is the same as the diameter d5 when viewed in the Z-axis direction. The diameter of the opening of the reflective layer 60 provided on the first electrode 40 is the same as the diameter d6 when viewed in the Z-axis direction.

In the embodiment, the configuration of the first electrode 40 when viewed in the Z-axis direction, the configuration of the opening of the foundation insulating layer 70 on the first electrode 40 when viewed in the Z-axis direction, and the configuration of the opening of the reflective layer 60 on the first electrode 40 when viewed in the Z-axis direction are arbitrary.

Thus, the foundation insulating layer 70 covers a portion of the first electrode 40 and a portion of the second electrode 50. Specifically, the foundation insulating layer 70 covers the portion of the first electrode 40 other than the portion connected to the first metal pillar 45. The foundation insulating layer 70 covers the portion of the second electrode 50 other than the portion connected to the second metal pillar 55.

The reflective layer 60 covers the portion of the foundation insulating layer 70 that covers the portion of the first electrode 40 (the portion of the first electrode 40 other than the portion connected to the first metal pillar 45). Also, the reflective layer 60 covers the portion of the foundation insulating layer that covers the portion of the second electrode 50 (the portion of the second electrode 50 other than the portion connected to the second metal pillar 55). For example, the reflective layer 60 covers the side surface of the foundation insulating layer 70.

As illustrated in FIG. 1B, the reflective layer 60 has a portion between the first electrode 40 and the first metal pillar 45. Further, the reflective layer 60 has a portion between the second electrode 50 and the second metal pillar 55. In other words, the first metal pillar 45 covers a portion of the reflective layer 60. The second metal pillar 55 covers another portion of the reflective layer 60.

As described below, the foundation insulating layer 70 may be provided if necessary and may be omitted in some cases.

Thus, in the specific example, the reflective layer 60 covers the edge portion and the side surface of the first electrode 40 and the edge portion and the side surface of the second electrode 50.

In the semiconductor light emitting device 110 according to the embodiment, a portion of the emitted light which is emitted from the light emitting unit 30 is emitted directly from the first major surface 15a to the outside. For example, another portion of the emitted light changes its travel direction by being reflected by the first electrode 40 and the second electrode 50 and is emitted from the first major surface 15a. Yet another portion of the emitted light changes its travel direction by being reflected by the reflective layer 60 provided at the side surface (the outer edge side surface 10s and the boundary side surface 10t) of the stacked body 15 and is emitted from the first major surface 15a.

In other words, in the semiconductor light emitting device 110, the emitted light which is emitted from the light emitting unit 30 is emitted from the first major surface 15a. Thereby, emissions from other surfaces are suppressed; and the light extraction efficiency is high. Thereby, a high efficiency is obtained.

For example, the reflective layer 60 covers the entire stacked body 15 except for the first major surface 15a, the opening on the first electrode 40 for the electrical connection, and the opening on the second electrode 50 for the electrical connection. Specifically, the outer edges of the p-side electrode 51 of the second electrode 50 and the first electrode 40 are covered with the foundation insulating layer 70. Then, the upper surface and the side surface of the foundation insulating layer 70 are covered with the reflective layer 60. Thereby, in the semiconductor light emitting device 110, the light is emitted only from the first major surface 15a. Thereby, a high light extraction efficiency is obtained.

The p-side conductive layer 52 functions to spread the current flowing between the first semiconductor layer 10 and the second semiconductor layer 20 over a surface area greater than the surface area of the p-side electrode 51. Thereby, the current can be caused to flow in a wider region of the stacked body 15; and the luminous efficiency can be increased. The p-side conductive layer 52 may be reflective or transmissive with respect to the emitted light which is emitted from the light emitting unit 30.

In the case where a light-reflective conductive layer is used as the p-side conductive layer 52, for example, the reflectance of the p-side conductive layer 52 is higher than the reflectance of the p-side electrode 51. In such a case, a portion of the emitted light is reflected by the p-side conductive layer 52 and travels toward the first major surface 15a. Thereby, a high light extraction efficiency is obtained.

In the case where a light-transmissive conductive layer is used as the p-side conductive layer 52, for example, the transmittance of the p-side conductive layer 52 is higher than the transmittance of the p-side electrode 51. Also, the transmittance of the p-side conductive layer 52 is higher than the transmittance of the reflective layer 60. In such a case, a portion of the emitted light passes through the p-side conductive layer 52, is reflected by the reflective layer 60, and travels toward the first major surface 15a. Thereby, a high light extraction efficiency is obtained.

In the semiconductor light emitting device 110, the heat generated in the light emitting unit 30 is conducted efficiently to the outside via the first metal pillar 45 and the second metal pillar 55. Thereby, good heat dissipation is obtained. Therefore, the temperature increase of the light emitting unit 30 can be suppressed; and the efficiency (the internal quantum efficiency) of the emission of the light of the light emitting unit 30 can be high.

In particular, in the specific example as illustrated in FIG. 1A and FIG. 2A, the surface area of the first metal pillar 45 is greater than the surface area of the first electrode 40 when viewed in the Z-axis direction. Also, the surface area of the second metal pillar 55 is greater than the surface area of the second electrode 50 when viewed in the Z-axis direction. Thus, the cross-sectional area of the first metal pillar 45 and the cross-sectional area of the second metal pillar 55 when cut by the X-Y plane can be set to be large. Therefore, the heat dissipation via the first metal pillar 45 and the second metal pillar 55 is high.

In the embodiment, for example, the reflective layer 60 which is insulative has a portion between the first electrode 40 and the first metal pillar 45. Thereby, for example, the first metal pillar 45 can overlay a portion of the second semiconductor layer 20 when viewed in the Z-axis direction. As a result, the cross-sectional area of the first metal pillar 45 can be large. Thereby, good heat dissipation is obtained.

Thus, in the semiconductor light emitting device 110 according to the embodiment, the light extraction efficiency emitted from the light emitting unit 30 is high; and the internal quantum efficiency also is high. Thereby, a semiconductor light emitting device having a high luminous efficiency is obtained.

The thickness of the first semiconductor layer 10 is, for example, not less than 1 µm and not more than 10 µm. In the specific example, the thickness of the first semiconductor layer 10 is about 5 µm. The thickness of the light emitting unit 30 is, for example, not less than 5 nanometers (nm) and not more than 100 nm. In the specific example, the thickness of the light emitting unit 30 is about 10 nm. The thickness of the second semiconductor layer 20 is, for example, not less than 5 nm and not more than 300 nm. In the specific example, the thickness of the second semiconductor layer 20 is about 100 nm.

In other words, the thickness of the stacked body 15 is not more than about 6 µm; and the mechanical strength of the stacked body 15 is low. In such a case, in the embodiment, the first metal pillar 45 and the second metal pillar 55 are provided to be connected to the first electrode 40 and the second electrode 50 which are provided on the stacked body 15; and the sealing unit 80 is provided. The stacked body 15 is reinforced by the first metal pillar 45, the second metal pillar 55, and the sealing unit 80. Thereby, in the semiconductor light emitting device 110, a practically sufficient strength is obtained.

In the specific example as illustrated in FIG. 2B, the thickness of the outer edge portion of the first semiconductor layer 10 is thinner than the thickness of the central portion (e.g., the second portion 12). In other words, the first semiconductor layer 10 further includes a third portion 13 juxtaposed with the second portion 12. The second portion 12 has a portion between the first portion 11 and the third portion 13. The thickness of the first portion 11 along the Z-axis direction and the thickness of the third portion 13 along the Z-axis direction are thinner than the thickness of the second portion 12 along the Z-axis direction.

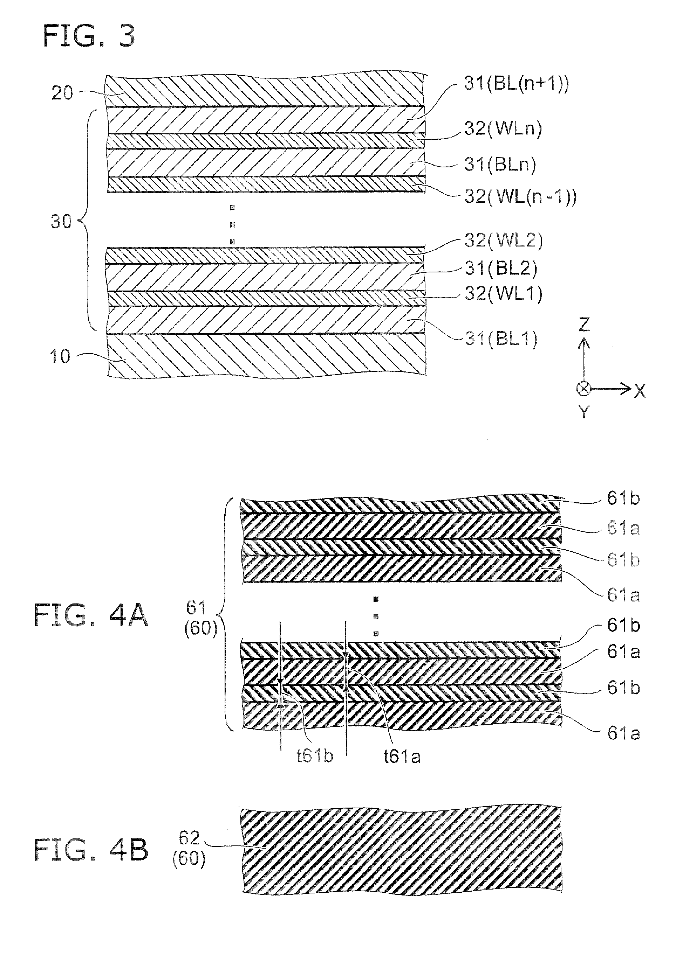

FIG. 3 is a schematic view illustrating the configuration of a portion of the semiconductor light emitting device according to the first embodiment. Namely, this drawing illustrates an example of the configuration of the light emitting unit 30.

As illustrated in FIG. 3, the light emitting unit 30 includes multiple well layers 32 and barrier layers 31 provided between the multiple well layers 32. In other words, the multiple well layers 32 and the multiple barrier layers 31 are alternately stacked along the Z axis.

The well layer 32 has a bandgap energy that is less than the bandgap energy of the multiple barrier layers 31. For example, the holes and the electrons of the well layer 32 recombine. Thereby, the light from the light emitting unit 30 is emitted.

For example, the well layer 32 includes Inₓ₁ Ga₁₋ₓ₁N (0 < x1 < 1). For example, the barrier layer 31 includes GaN. In other words, the barrier layer 31 substantially does not include In. In the case where the barrier layer 31 includes In, the In composition ratio of the barrier layer 31 is lower than the In composition ratio of the well layer 32.

The light emitting unit 30 may have a multiple quantum well (MQW) configuration. In such a case, the light emitting unit 30 includes not less than three barrier layers 31 and the well layers 32 provided respectively in the regions between the barrier layers 31.

The light emitting unit 30 includes, for example, n+1 barrier layers 31 and n well layers 32 (where n is an integer not less than 2). The first barrier layer BL1 to the (n+1)th barrier layer BL(n+1) are juxtaposed in this order from the first semiconductor layer 10 toward the second semiconductor layer 20. The ith well layer WLi (where i is an integer not less than 1 and not more than n) is provided between the ith barrier layer BLi and the (i+1)th barrier layer BL(i+1).

The peak wavelength of the light (the emitted light) emitted from the light emitting unit 30 is, for example, not less than 350 nm and not more than 700 nm.

The light emitting unit 30 may have a single quantum well (SQW) configuration. In such a case, the light emitting unit 30 includes two barrier layers 31 and the well layer 32 provided between the barrier layers 31.

In the embodiment, the configuration of the light emitting unit 30 is arbitrary.

FIG. 4A and FIG. 4B are schematic cross-sectional views illustrating the configuration of a portion of the semiconductor light emitting device according to the first embodiment.

Namely, these drawings illustrate two examples of the configuration of the reflective layer 60.

As illustrated in FIG. 4A, a multilayered dielectric film 61 (e.g., a DBR (Distributed Bragg Reflector)) may be used as the reflective layer 60. In other words, the reflective layer 60 may include multiple first dielectric layers 61a and multiple second dielectric layers 61b. The first dielectric layers 61a and the second dielectric layers 61b are alternately stacked and have mutually different refractive indexes. For example, a thickness t61a of the first dielectric layer 61a is set to be substantially λ/(4n1), where the refractive index of the first dielectric layer 61a is n1 and the wavelength (e.g., the peak wavelength) of the emitted light which is emitted from the light emitting unit 30 is λ. For example, a thickness t61b of the second dielectric layer 61b is set to be substantially λ/(4n2), where the refractive index of the second dielectric layer 61b is n2. Thereby, the emitted light can be efficiently reflected. Thereby, the emitted light can be efficiently emitted from the first major surface 15a to the outside.

The first dielectric layer 61a includes, for example, silicon oxide; and the second dielectric layer 61b includes, for example, silicon nitride. However, the embodiment is not limited thereto. The first dielectric layer 61a and the second dielectric layer 61b may include any insulative material.

The number of the first dielectric layers 61a and the number of the second dielectric layers 61b may be two or more and are arbitrary. For example, sputtering, CVD (Chemical Vapor Deposition), etc., may be used to form the first dielectric layer 61a and the second dielectric layer 61b.

As illustrated in FIG. 4B, a reflecting insulating film 62 can be used as the reflective layer 60. For example, the reflective layer 60 (the reflecting insulating film 62) may include at least one selected from the group consisting of zinc oxide (ZnO), titanium dioxide (TiO₂), zirconium oxide (ZrO₂) aluminum oxide (Al₂O₃), magnesium oxide (MgO), calcium titanate (CaTiO₂) barium sulfate (BaSO₄), zinc sulfide (ZnS), and calcium carbonate (CaCO₃). These materials reflect the emitted light and are electrically insulative. The reflective layer 60 may include a material that is substantially white. It is not always necessary for the reflective layer 60 to be white; and the reflective layer 60 may include any insulating material having a high reflectance with respect to the emitted light (e.g., a metal oxide, a compound including a metal, etc.).

For example, sputtering, vapor deposition, CVD, etc., may be used to form the reflecting insulating film 62.

However, in the embodiment, the method for forming the reflective layer 60 (the reflecting insulating film 62, or the first dielectric layer 61a and the second dielectric layer 61b) is arbitrary.

The thickness of the reflective layer 60 may be, for example, not less than 10 nm and not more than 10,000 nm. The thickness of the reflective layer 60 is appropriately set based on the aspects of the optical characteristics (e.g., the reflectance), the electrical characteristics (e.g., the insulative properties), and the productivity.

In the case where a reflecting insulating film 62 of a TiO₂ film is used as the reflective layer 60, the thickness of the reflective layer 60 is set to be, for example, about 1,000 nm.

The foundation insulating layer 70 may include at least one selected from silicon oxide and silicon nitride. For example, the foundation insulating layer 70 may include an inorganic material such as SiO₂ SiN, phosphosilicate glass (PSG), boron phosphosilicate glass (BPSG), etc. For example, the foundation insulating layer 70 is formed by CVD. In such a case, the thickness of the foundation insulating layer 70 may be, for example, not less than 10 nm and not more than 10,000 nm. Specifically, the thickness of the foundation insulating layer 70 is about 400 nm. Other than CVD, the foundation insulating layer 70 may be formed by vapor deposition, sputtering, etc.

Further, a glass material such as organic SOG (Spin On Glass), inorganic SOG, etc., may be used as the foundation insulating layer 70. For example, a methylsilsesquioxane film may be used as the organic SOG film. A hydrogen silsesquioxane film may be used as the inorganic SOG film. For example, a film formed by coating an alcohol solution of silanol and performing heat treatment may be used as the inorganic SOG film.

A low dielectric constant inter-layer insulating film (a low-k film) and the like may be used as the foundation insulating layer 70. Also, a resin material such as polyimide, polybenzoxazole (PBO), a silicone material, etc., may be used as the foundation insulating layer 70. In such a case, the thickness of the foundation insulating layer 70 is set to be, for example, not less than 1,000 nm and not more than 20,000 nm.

The reflectance of the foundation insulating layer 70 with respect to the emitted light is lower than the reflectance of the reflective layer 60 with respect to the emitted light; and the foundation insulating layer 70 may include, for example, a transparent material.

The p-side conductive layer 52 may include any conductive material. The p-side conductive layer 52 may function as a contact electrode for the second semiconductor layer 20.

For example, a film including at least one selected from Ni, Au, Ag, Al, and Pd may be used as the p-side conductive layer 52. A stacked film including at least two selected from a Ni film, a Au film, a Ag film, an Al film, and a Pd film may be used as the p-side conductive layer 52.

In particular, a Ag film, an Al film, a Pd film, or a stacked film including at least two selected from a Ag film, an Al film, and a Pd film may be used as the p-side conductive layer 52. Thereby, in particular, a high reflectance with respect to light having a short wavelength (ultraviolet light to blue light) is obtained. Thereby, a high light extraction efficiency is obtained.

Further, a transparent metal oxide may be used as the p-side conductive layer 52. For example, at least one selected from ITO (Indium Tin Oxide), SnO₂ In₂O₃, and ZnO may be used as the p-side conductive layer 52.

For example, sputtering, vapor deposition, etc., may be used to form the p-side conductive layer 52. In the case where the p-side conductive layer 52 is a single layer, the thickness of the p-side conductive layer 52 is, for example, 0.2 µm.

The p-side electrode 51 and the first electrode 40 may include, for example, a stacked film of a Ni film and a Au film. In such a case, the thickness of the Ni film is, for example, about 100 nm; and the thickness of the Au film is, for example, about 100 nm. Or, the p-side electrode 51 and the first electrode 40 may include, for example, a stacked film of a Ti film, a Ni film, and a Au film. In such a case, the thickness of the Ti film is, for example, 50 nm; the thickness of the Ni film is, for example, about 100 nm; and the thickness of the Au film is, for example, about 100 nm.

It is favorable for the material, the thickness, and the configuration of the p-side electrode 51 to be the same as the material, the thickness, and the configuration of the first electrode 40. For example, sputtering and vapor deposition may be used to form the p-side electrode 51 and the first electrode 40.

The sealing unit 80 may include, for example, an insulative resin such as an epoxy resin, etc. The sealing unit 80 may include, for example, a quartz filler, an alumina filler, etc. By including such fillers, the thermal conductivity of the sealing unit 80 can be increased; and the heat dissipation can be improved.

The sealing unit 80 may include, for example, a filler including at least one selected from the group consisting of ZnO, TiO₂, ZrO₂ Al₂O₃, MgO, CaTiO₂, BaSO₄, ZnS, and CaCO₃. Thereby, the reflectance of the sealing unit 80 increases; the sealing unit 80 functions as a reflective film with the reflective layer 60; and the leak light from surfaces of the stacked body 15 other than the first major surface 15a can be suppressed further. Also, for example, the light emitted from the first major surface 15a that returns by being reflected by structural bodies of the periphery can be efficiently reflected; and the utilization efficiency of the light can be increased.

A mixture of the filler recited above that increases the thermal conductivity and the filler recited above that increases the reflectance may be used.

However, the embodiment is not limited thereto. The sealing unit 80 may include any insulating material. A filler may not be included.

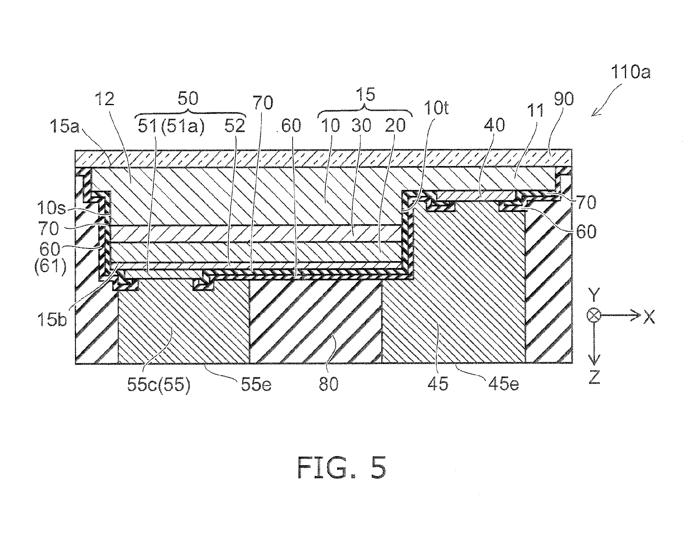

FIG. 5 is a schematic cross-sectional view illustrating the configuration of another semiconductor light emitting device according to the first embodiment.

As illustrated in FIG. 5, the semiconductor light emitting device 110a according to the embodiment further includes a wavelength conversion layer 90. Otherwise, the semiconductor light emitting device 110a is similar to the semiconductor light emitting device 110, and a description is therefore omitted.

The wavelength conversion layer 90 is provided on at least a portion of the first major surface 15a of the stacked body 15. The wavelength conversion layer 90 absorbs a portion of the emitted light and emits light of a wavelength different from the wavelength of the emitted light. For example, the wavelength conversion layer 90 may include a fluorescer layer. A stacked film of multiple fluorescer layers that emit light of mutually different wavelengths may be used as the wavelength conversion layer 90. For example, the light emitted from the light emitting unit 30 is ultraviolet light, violet light, or blue light; and the light emitted from the wavelength conversion layer 90 is yellow light or red light. For example, the synthesized light of the emitted light and the light (the converted light) emitted from the wavelength conversion layer 90 is substantially white light.

In this example, the wavelength conversion layer 90 covers the entire first major surface 15a. The embodiment is not limited thereto. A portion of the first major surface 15a may not be covered with the wavelength conversion layer 90.

One example of a method for manufacturing the semiconductor light emitting device 110a will now be described as an example of a method for manufacturing the semiconductor light emitting device according to the embodiment. In this example, the multiple semiconductor light emitting devices 110a are collectively formed on the substrate.

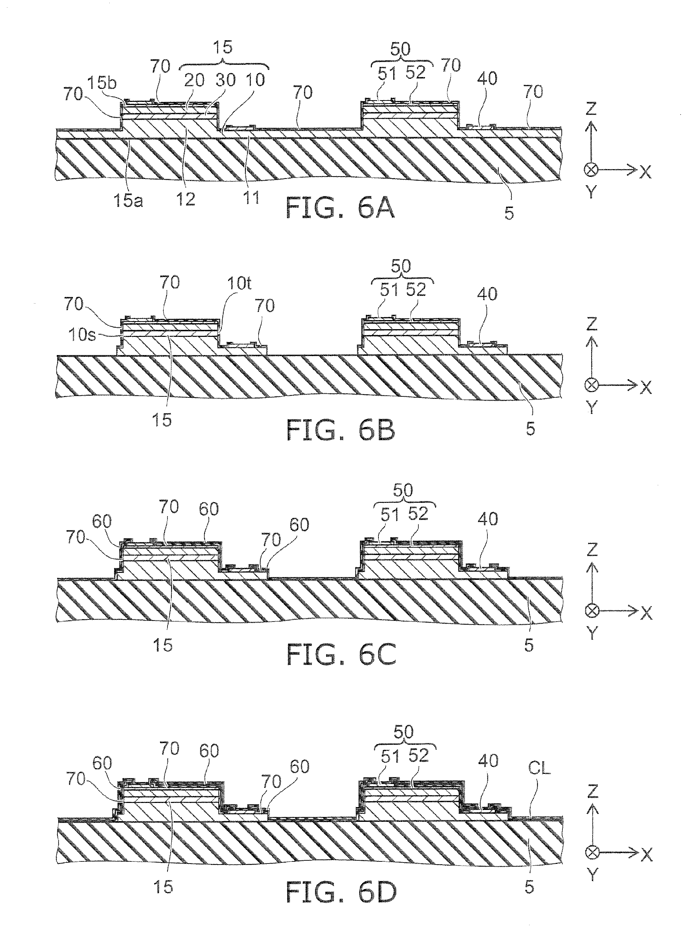

FIG. 6A to FIG. 6D, FIG. 7A to FIG. 7C, and FIG. 8A to FIG. 8C are schematic cross-sectional views in order of the processes, illustrating the method for manufacturing the semiconductor light emitting device according to the first embodiment.

As illustrated in FIG. 6A, a stacked crystal film of the first semiconductor layer 10, the light emitting unit 30, and the second semiconductor layer 20 is sequentially and epitaxially grown on a substrate 5. The stacked crystal film is used to form the stacked body 15.

The substrate 5 may include, for example, sapphire (Al₂O₃), silicon carbide (SiC), spinel (MgAl₂O₄), silicon (Si), etc. The substrate 5 may include, for example, substantially the same material as the stacked body 15. For example, it is favorable for the lattice constant and the coefficient of thermal expansion of the material of the substrate 5 to be near those of the stacked body 15. However, in the embodiment, the substrate 5 may include any material. The thickness of the substrate 5 is, for example, not less than 30 µm and not more than 5,000 µm.

For example, metal organic chemical vapor deposition (MOCVD), hydride vapor phase epitaxy (HVPE), molecular beam epitaxy (MBE), etc., may be used to epitaxially grow the stacked crystal film on the substrate 5. If necessary, a buffer layer (not illustrated) may be formed on the substrate 5; and the stacked crystal film may be epitaxially grown on this buffer layer.

After the growth of the stacked crystal film, a portion of the stacked crystal film is removed. Thereby, the multiple stacked bodies 15 are formed. Then, the second electrode 50 (the p-side conductive layer 52 and the p-side electrode 51) is formed on the second semiconductor layer 20; and the first electrode 40 is formed on the first semiconductor layer 10.

Continuing, the foundation insulating layer 70 is formed on the side surface (the outer edge side surface 10s and the boundary side surface 10t) of the stacked body 15. An opening is provided in the foundation insulating layer 70 to expose a portion of the first electrode 40; and an opening is provided in the foundation insulating layer 70 to expose a portion of the second electrode 50.

Subsequently, as illustrated in FIG. 6B, the multiple stacked bodies 15 are obtained by dividing the first semiconductor layer 10.

As illustrated in FIG. 6C, the reflective layer 60 is formed on the foundation insulating layer 70. The reflective layer 60 covers the side surface (the outer edge side surface 10s and the boundary side surface 10t) of the stacked body 15. As described above, for example, the reflective layer 60 is formed to cover the side surface of the foundation insulating layer 70.

As illustrated in FIG. 6D, a conductive layer CL is formed on the entire surface of the patterning body. For example, the conductive layer CL is formed by vapor deposition, sputtering, etc. For example, the conductive layer CL functions as a seed layer in processes that are described below.

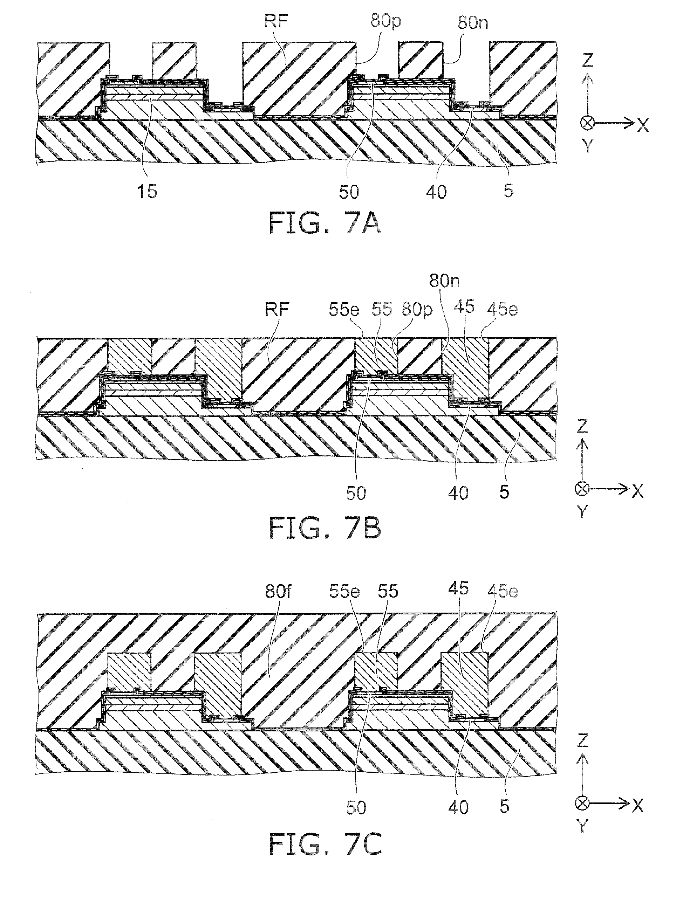

As illustrated in FIG. 7A, a resist film RF is formed on the patterning body. The resist film RF has openings 80n and 80p that have prescribed configurations. The opening 80n communicates with the first electrode 40 and is where the first metal pillar 45 is formed. The opening 80p communicates with the second electrode 50 and is where the second metal pillar 55 is formed.

As illustrated in FIG. 7B, a metal is filled into the opening 80n and the opening 80p by a method such as, for example, plating and the like; and the surface is planarized if necessary. Thereby, the first metal pillar 45 and the second metal pillar 55 are formed. The conductive layer CL at the opening 80n is taken to be included in the first metal pillar 45. The conductive layer CL at the opening 80p is taken to be included in the second metal pillar 55.

As illustrated in FIG. 7C, the resist film RF is removed; and the conductive layer CL that is exposed is removed. Subsequently, a sealing insulating film 80f that is used to form the sealing unit 80 is formed to cover the entire patterning body. For example, an epoxy resin layer is formed as the sealing insulating film 80f. The sealing insulating film 80f buries the end portion 45e of the first metal pillar 45 and the end portion 55e of the second metal pillar 55.

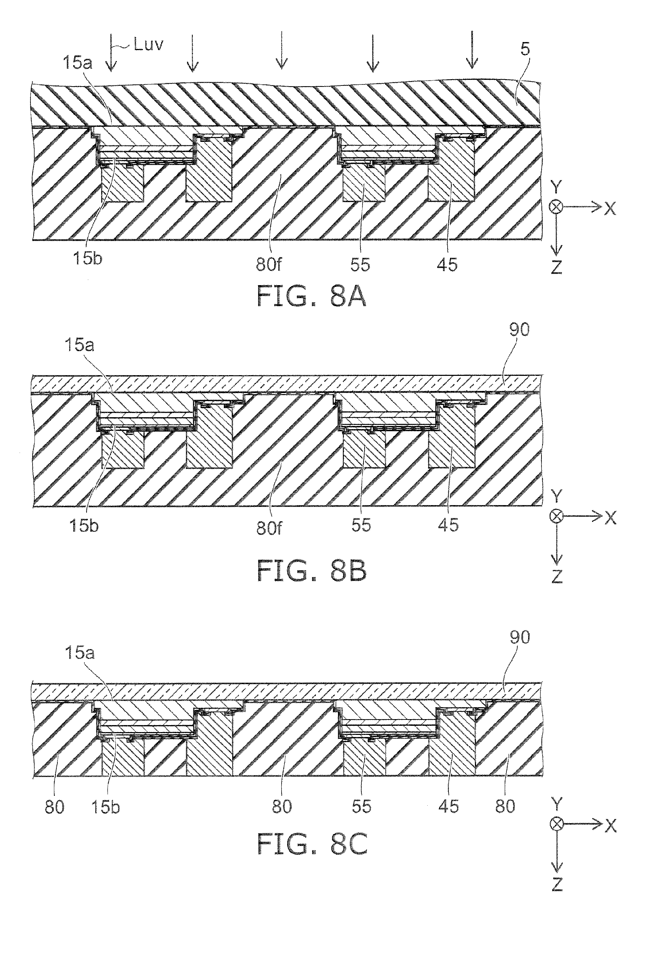

As illustrated in FIG. 8A, ultraviolet light Luv is irradiated onto the first major surface 15a of the stacked body 15 via the substrate 5. Thereby, a portion of the stacked body 15 on the substrate 5 side decomposes. As a result, the stacked body 15 and the substrate 5 separate from each other. Thus, in the embodiment, the stacked body 15 is formed by the stacked film (the stacked crystal film) used to form the stacked body 15 being epitaxially grown on the substrate 5, and by the stacked film subsequently being separated from the substrate 5. Thereby, the first major surface 15a is exposed.

The stacked film (the stacked crystal film) is supported by the sealing insulating film 80f. By using a resin material as the sealing insulating film 80f, the sealing insulating film 80f is flexible and deforms easily. Thereby, stress is not easily applied to the stacked film when the stacked film (the stacked body 15) and the substrate 5 are separated from each other. Thereby, the substrate 5 can be separated while suppressing damage to the stacked film.

As illustrated in FIG. 8B, the wavelength conversion layer 90 is formed on the first major surface 15a. Then, as illustrated in FIG. 8C, the sealing insulating film 80f is cut away to expose the first metal pillar 45 and the second metal pillar 55.

Subsequently, subdivision into the multiple stacked bodies 15 is performed to collectively obtain the multiple semiconductor light emitting devices 110a.

The semiconductor light emitting device 110 can be formed by omitting the wavelength conversion layer 90 from the processes recited above.

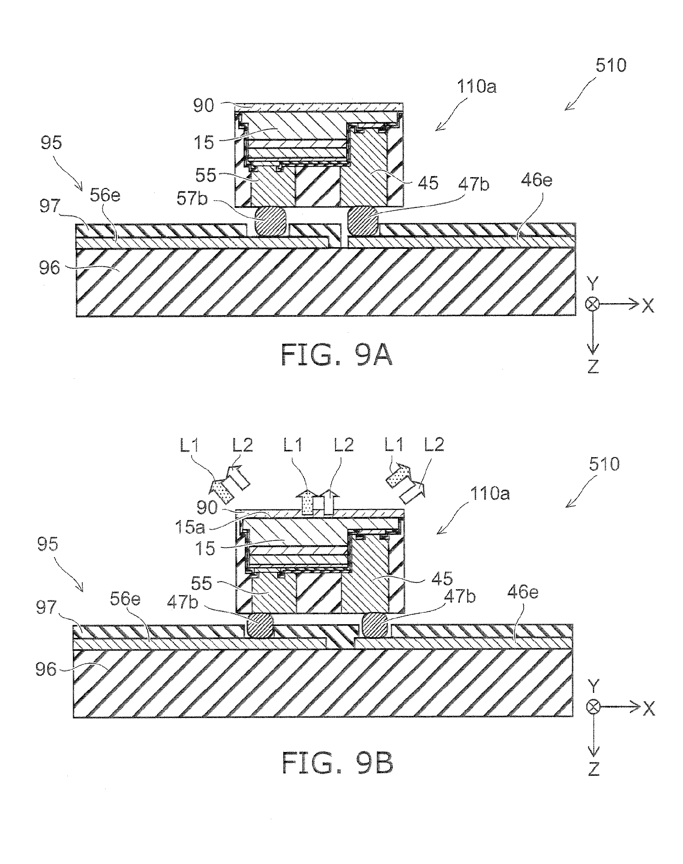

FIG. 9A and FIG. 9B are schematic cross-sectional views illustrating the operation of the semiconductor light emitting device according to the first embodiment.

As illustrated in FIG. 9A, the semiconductor light emitting device 110a is mounted on a mounting part 95. In other words, the light emitting apparatus 510 includes the semiconductor light emitting device 110a and the mounting part 95. The mounting part 95 includes a base body 96, an n-side interconnect 46e, a p-side interconnect 56e, and an insulating layer 97. The n-side interconnect 46e and the p-side interconnect 56e are provided on the base body 96. The insulating layer 97 is provided on the n-side interconnect 46e while leaving a portion of the n-side interconnect 46e exposed. The insulating layer 97 is provided on the p-side interconnect 56e while leaving a portion of the p-side interconnect 56e exposed. The portion of the n-side interconnect 46e exposed from the insulating layer 97 opposes the first metal pillar 45 of the semiconductor light emitting device 110a. The portion of the p-side interconnect 56e exposed from the insulating layer 97 opposes the second metal pillar 55. An n-side connection member 47b is provided between the n-side interconnect 46e and the first metal pillar 45. A p-side connection member 57b is provided between the p-side interconnect 56e and the second metal pillar 55.

As illustrated in FIG. 9B, emitted light L1 emitted from the light emitting unit 30 (not illustrated in this drawing) of the stacked body 15 is emitted from the first major surface 15a. The wavelength of a portion of the emitted light L1 is converted to form converted light L2.

In such a case, the proportion of the emitted light L1 and the converted light L2 is substantially the same between the Z axis (the line normal to the first major surface 15a) and directions tilted from the Z axis. In other words, in the semiconductor light emitting device 110a and the light emitting apparatus 510 according to the embodiment, light of a uniform color is obtained regardless of the emergence angle.

Although the wavelength conversion layer 90 is provided in the semiconductor light emitting device 110a in this example, the embodiment is not limited thereto. The wavelength conversion layer 90 may be formed on at least a portion of the first major surface 15a of the semiconductor light emitting device 110 after mounting the semiconductor light emitting device 110 on the mounting part 95.

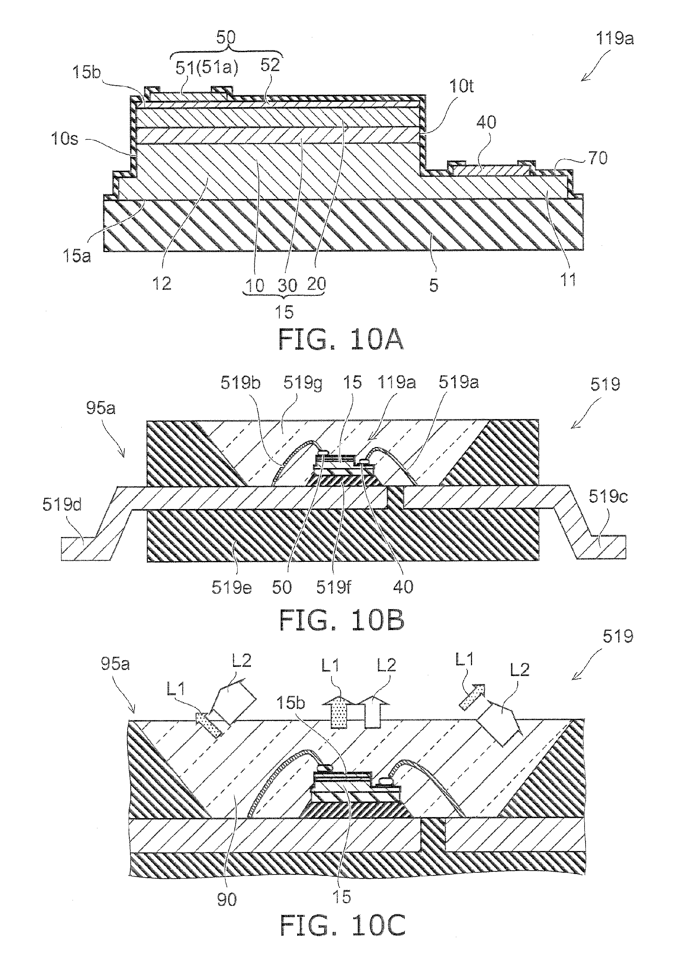

FIG. 10A to FIG. 10C are schematic cross-sectional views illustrating the configuration and the operation of a semiconductor light emitting device of a first reference example.

As illustrated in FIG. 10A, the stacked body 15, the first electrode 40, the second electrode 50, the substrate 5, and the foundation insulating layer 70 are provided in the semiconductor light emitting device 119a of the first reference example. The reflective layer 60 is not provided. In such a case as well, the second electrode 50 includes the p-side electrode 51 and the p-side conductive layer 52. The p-side conductive layer 52 is formed of light-shielding fine wire electrodes or a transparent electrode.

The foundation insulating layer 70 covers the side surface of the stacked body 15. The foundation insulating layer 70 is transparent.

In the semiconductor light emitting device 119a, the light is emitted mainly from the second major surface 15b side. However, light is emitted also from the side surface of the stacked body 15 because the reflective layer is not provided on the side surface of the stacked body 15. A portion of the emitted light reaches the substrate 5 and is emitted also from the first major surface 15a.

As illustrated in FIG. 10B, the semiconductor light emitting device 119a is mounted on a mounting part 95a. In other words, the light emitting apparatus 519 of the reference example includes the semiconductor light emitting device 119a and the mounting part 95a. The mounting part 95a includes an n-side frame 519c and a p-side frame 519d. The semiconductor light emitting device 119a is fixed on the p-side frame 519d by a bonding member 519f (e.g., a resin), etc. The first electrode 40 of the semiconductor light emitting device 119a is connected to the n-side frame 519c by an n-side wire 519a. The second electrode 50 is connected to the p-side frame 519d by a p-side wire 519b. The semiconductor light emitting device 119a is stored inside a reflecting container 519e. A fluorescer resin 519g that contains a fluorescer is provided on the semiconductor light emitting device 119a.

As illustrated in FIG. 10C, the emitted light L1 emitted from the light emitting unit 30 (not illustrated in this drawing) of the stacked body 15 is emitted from the side surface and the lower surface of the stacked body 15 and the substrate 5 as well as being emitted from the second major surface 15b. For example, the light emitted from the side surface and the lower surface is reflected by the frame and the wall surface of the reflecting container 519e recited above and travels toward the upward direction. The light emitted from the various surfaces such as the second major surface 15b, the side surface, the lower surface, etc., passes through the fluorescer resin 519g. Then, the wavelength of a portion of the emitted light L1 is converted to form the converted light L2.

In such a case, the proportion of the emitted light L1 and the converted light L2 is different between the direction along the Z axis and directions tilted with respect to the Z axis. In other words, the optical path lengths of the emitted light L1 propagating through the fluorescer resin 519g in directions tilted with respect to the Z axis are longer than the optical path length of the emitted light L1 propagating through the fluorescer resin 519g in the direction along the Z axis. Therefore, the proportions of the converted light L2 in the directions tilted with respect to the Z axis are higher than the proportion of the converted light L2 in the direction along the Z axis. Therefore, the wavelength characteristics of the emitted light (the synthesized light of the emitted light L1 and the converted light L2) are different between the direction along the Z axis and the directions tilted with respect to the Z axis.

For example, the emitted light L1 is blue and the converted light L2 is yellow. In the first reference example, the intensity of the yellow of the light emitted in oblique directions is higher than that of the front direction (the direction parallel to the Z axis). For example, in the case where white light is obtained in the front direction, the light in the oblique directions has a yellow tint. Therefore, light of the same color is not obtained in all directions. In other words, in the semiconductor light emitting device 119a and the light emitting apparatus 519 of the first reference example, the color of the emitted light changes by angle. In other words, the unevenness of the color of the light that is emitted is large.

For example, the light emitted from the lower surface is reflected by the frame and the reflecting container 519e and is absorbed as it travels; and at least a portion of this light is lost.

Also, in the semiconductor light emitting device 119a and the light emitting apparatus 519, the heat dissipation is poor because a substrate 5 that has a low thermal conductivity is provided. The light extraction efficiency is low because the light is shielded by the first electrode 40 and the second electrode 50 because a configuration is used in which the light is emitted from the second major surface 15b where the first electrode 40 and the second electrode 50 are provided.

Conversely, in the semiconductor light emitting device 110a and the light emitting apparatus 510 according to the embodiment, the proportion of the emitted light L1 and the converted light L2 is substantially the same between the Z axis and the directions tilted from the Z axis because the light is emitted substantially only from the first major surface 15a. Thereby, light of a uniform color is obtained regardless of the emergence angle. The loss of the light is suppressed because the light substantially is not emitted from surfaces other than the first major surface 15a. Further, the heat that is generated is efficiently conducted to the outside (e.g., the n-side interconnect 46e, the p-side interconnect 56e, etc.) via the n-side connection member 47b and the p-side connection member 57b because the first metal pillar 45 and the second metal pillar 55 are used without using the substrate 5. Thereby, good heat dissipation is obtained. Also, electrodes (the first electrode 40, the second electrode 50, etc.) that shield the light are not provided on the first major surface 15a where the light is emitted. Thereby, a high light extraction efficiency is obtained.

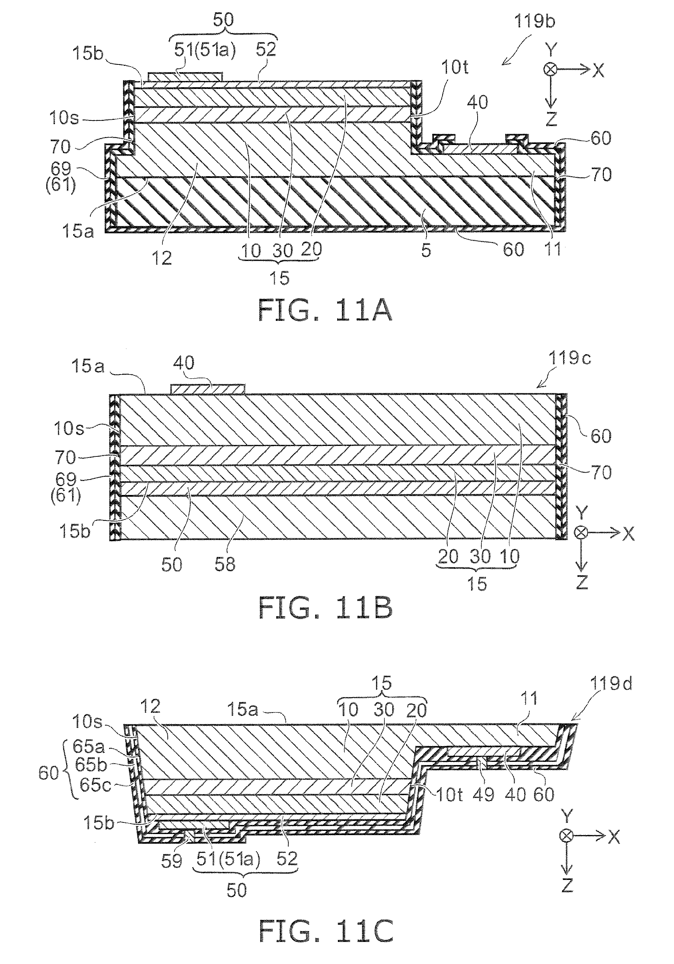

FIG. 11A to FIG. 11C are schematic cross-sectional views illustrating the configurations of semiconductor light emitting devices of second to fourth reference examples.

In the semiconductor light emitting device 119b of the second reference example as illustrated in FIG. 11A, a reflective layer 69 is further provided on the side surface of the stacked body 15 and the lower surface of the substrate 5 of the semiconductor light emitting device 119a. In the semiconductor light emitting device 119b, the light emitted from the side surface of the stacked body 15 and the lower surface of the substrate 5 is reflected toward the second major surface 15b by the reflective layer 69. Thereby, the change of the color due to the change of the optical path length is suppressed. However, a portion of the light is shielded because the first electrode 40 and the second electrode 50 are provided on the second major surface 15b where the light is emitted. Therefore, the light extraction efficiency is low. Because the substrate 5 is provided, the heat dissipation is poor; and a high luminous efficiency cannot be obtained.

In the semiconductor light emitting device 119c of the third reference example as illustrated in FIG. 11B, the first electrode 40 is provided on the first major surface 15a of the stacked body 15; and the second electrode 50 is provided on the second major surface 15b of the stacked body 15. Then, the substrate 5 for the crystal growth is removed. Continuing, a support substrate 58 (e.g., a conductive substrate such as a silicon substrate) is bonded to the second electrode 50. The foundation insulating layer 70 is provided on the side surface of the stacked body 15; and the reflective layer 69 is provided to cover the foundation insulating layer 70. In this example, the light is emitted mainly from the first major surface 15a. In such a case as well, a portion of the light is shielded because the first electrode 40 is provided on the first major surface 15a where the light is emitted; and the light extraction efficiency is low.

In the semiconductor light emitting device 119d of the fourth reference example as illustrated in FIG. 11C, the reflective layer 60 is provided on the side surface of the stacked body 15. In this example, multiple dielectric films (dielectric films 65a, 65b, and 65c) are provided as the reflective layer 60. A first lead electrode portion 49 that is connected to the first electrode 40 and a second lead electrode 59 that is connected to the second electrode 50 are provided. The sealing unit 80 is not provided. Therefore, the strength of the semiconductor light emitting device 119d is low; the semiconductor light emitting device 119d destructs easily during the mounting; and the semiconductor light emitting device 119d is impractical. In the semiconductor light emitting device 119d, although the problem of the strength being low is mitigated in the case where the substrate 5 for the crystal growth remains, the heat dissipation is insufficient.

Conversely, in the semiconductor light emitting devices 110 and 110a according to the embodiment, the strength is high, the devices are practical, good heat dissipation is obtained, and a high luminous efficiency is obtained because the sealing unit 80 is provided to seal the first metal pillar 45, the second metal pillar 55, and the stacked body 15.

A configuration may be considered in which a conductive reflective layer is provided on the side surface (the outer edge side surface 10s) of the stacked body 15. However, in such a configuration, an inter-layer insulating film must be separately provided between the first metal pillar 45 and the second semiconductor layer 20 (and the p-side conductive layer 52) when the cross-sectional area of the first metal pillar 45 is to be increased.

Conversely, in the semiconductor light emitting devices 110 and 110a according to the embodiment, the reflective layer 60 can be utilized as an insulating layer to electrically isolate the first metal pillar 45 from the second semiconductor layer 20 (and the p-side conductive layer 52) because the reflective layer 60 that is provided on the side surface of the stacked body 15 is insulative. In other words, the reflective layer 60 has both the insulating function of an inter-layer insulating film and a reflecting function. Thereby, the configuration is simple, and the number of processes can be reduced. Because the reflective layer 60 is insulative, the insulative properties of the device can be increased; and higher reliability is obtained.

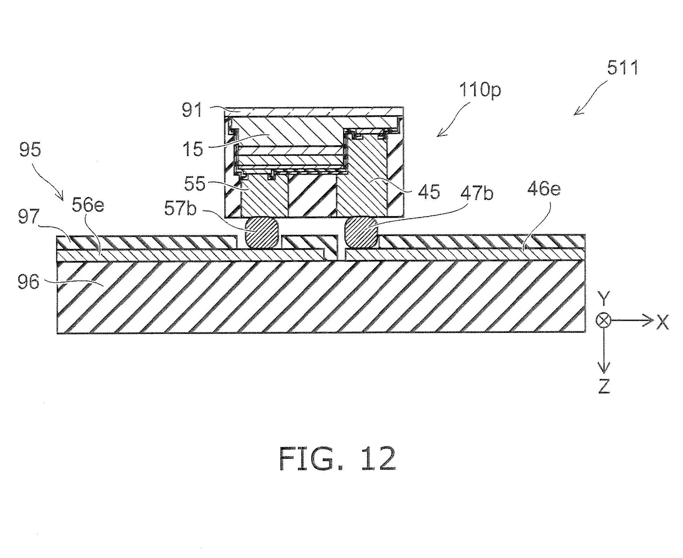

FIG. 12 is a schematic cross-sectional view illustrating the configuration of another semiconductor light emitting device according to the first embodiment.

As illustrated in FIG. 12, the semiconductor light emitting device 110p according to the embodiment further includes a transparent layer 91. The transparent layer 91 is provided on at least a portion of the first major surface 15a of the stacked body 15. The transparent layer 91 is transmissive with respect to the emitted light. The light emitting apparatus 511 includes the semiconductor light emitting device 110p and the mounting part 95.

For example, the transparent layer 91 protects the first major surface 15a of the stacked body 15. A material having a refractive index lower than the refractive index of the first semiconductor layer 10 may be used as the transparent layer 91. Thereby, the light emitted from the light emitting unit 30 can be efficiently emitted from the first major surface 15a. In such a case as well, a semiconductor light emitting device having high efficiency can be provided.

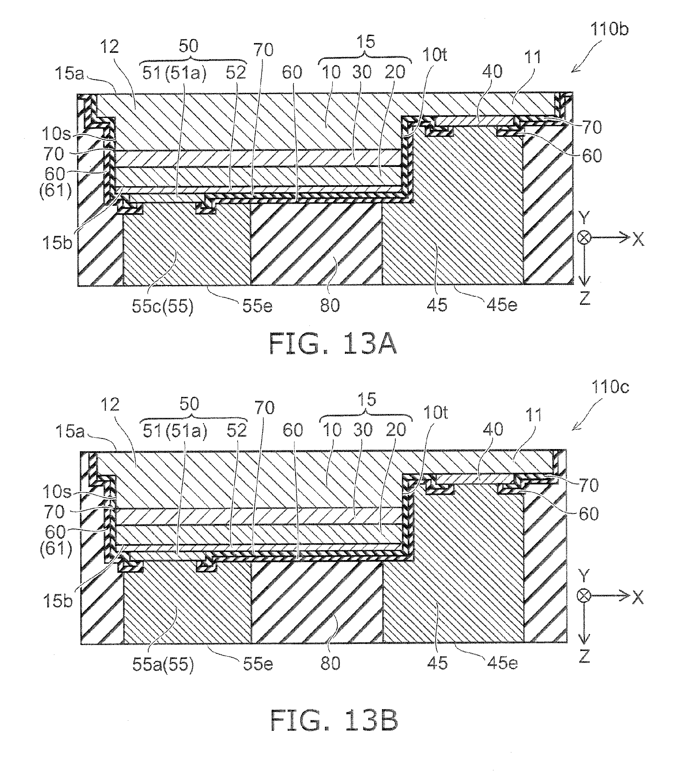

FIG. 13A and FIG. 13B are schematic cross-sectional views illustrating the configuration of another semiconductor light emitting device according to the first embodiment.

In the semiconductor light emitting device 110b according to the embodiment as illustrated in FIG. 13A, the foundation insulating layer 70 covers the entire side surface of the portion of the outer edge of the first semiconductor layer 10. Thereby, more stable characteristics are obtained.

In the semiconductor light emitting device 110b, the foundation insulating layer 70 covers the entire outer edge side surface 10s and the entire boundary side surface 10t. Thereby, more stable characteristics are obtained.

In the semiconductor light emitting device 110b, the reflective layer 60 is exposed at the side surface of the sealing unit 80.

On the other hand, in the semiconductor light emitting device 110c as illustrated in FIG. 13B, the foundation insulating layer 70 covers the interface portion of the outer edge side surface 10s between the first semiconductor layer 10 and the light emitting unit 30, the interface portion of the outer edge side surface 10s between the second semiconductor layer 20 and the light emitting unit 30, the interface portion of the boundary side surface 10t between the first semiconductor layer 10 and the light emitting unit 30, and the interface portion of the boundary side surface 10t between the second semiconductor layer 20 and the light emitting unit 30. Thereby, the stacked body 15 can be protected.

In the semiconductor light emitting device 110c, the side surface of the reflective layer 60 is covered with the sealing unit 80. Thus, various modifications are possible.

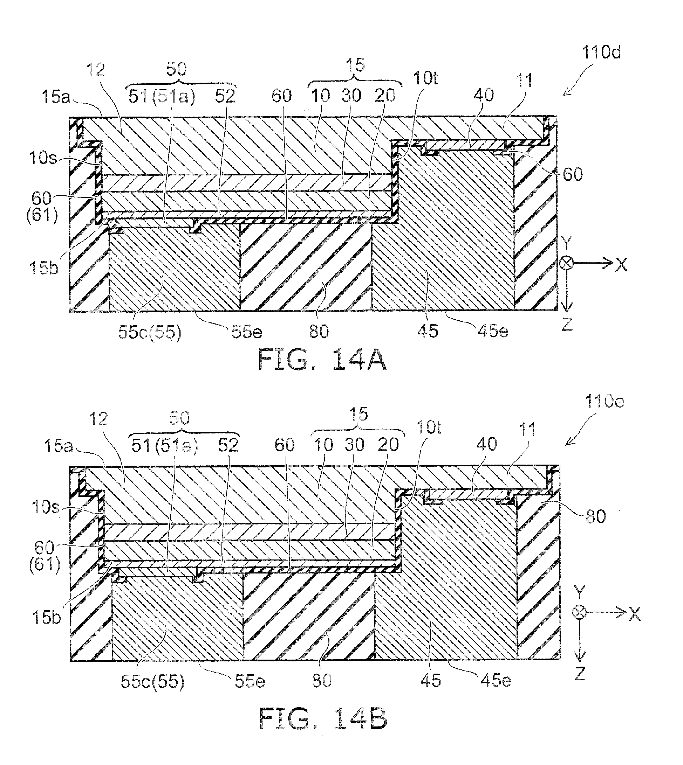

FIG. 14A and FIG. 14B are schematic cross-sectional views illustrating the configurations of other semiconductor light emitting devices according to the first embodiment.

As illustrated in FIG. 14A, the foundation insulating layer 70 is not provided in the semiconductor light emitting device 110d according to the embodiment. In the embodiment, the reflective layer 60 is simultaneously reflective and insulative. Therefore, the reflective layer 60 can function as the foundation insulating layer 70. Thus, the foundation insulating layer 70 may be provided if necessary and may be omitted. In this example, the reflective layer 60 is not provided at the side surface of the portion of the outer edge of the first semiconductor layer 10. In other words, the reflective layer 60 covers the interface portion of the outer edge side surface 10s between the first semiconductor layer 10 and the light emitting unit 30, the interface portion of the outer edge side surface 10s between the second semiconductor layer 20 and the light emitting unit 30, the interface portion of the boundary side surface 10t between the first semiconductor layer 10 and the light emitting unit 30, and the interface portion of the boundary side surface 10t between the second semiconductor layer 20 and the light emitting unit 30. Thereby, the stacked body 15 can be practically and sufficiently protected.

In the semiconductor light emitting device 110e according to the embodiment as illustrated in FIG. 14B, the reflective layer 60 also covers the side surface of the portion of the outer edge of the first semiconductor layer 10. Thus, the reflective layer 60 can cover the entire outer edge side surface 10s and the entire boundary side surface 10t. Thereby, more stable characteristics are obtained.

In the semiconductor light emitting device 110d, the sealing unit 80 leaves the side surface of the portion of the reflective layer 60 that contacts the first major surface 15a exposed. In the semiconductor light emitting device 110e, the sealing unit 80 covers the reflective layer 60 except for the portion of the reflective layer 60 exposed at the first major surface 15a. Thus, the sealing unit 80 covers at least a portion of the reflective layer 60.

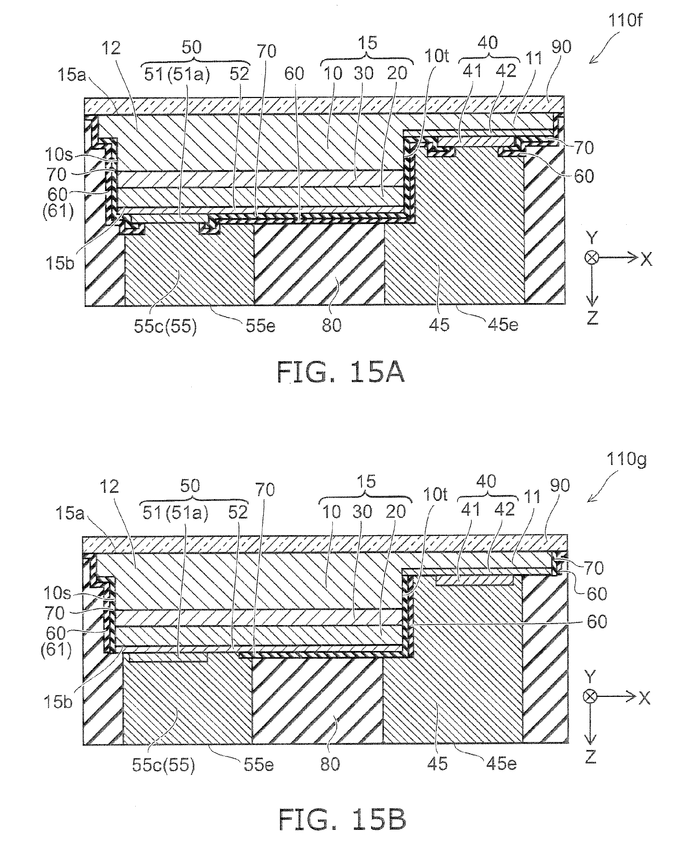

FIG. 15A and FIG. 15B are schematic cross-sectional views illustrating the configurations of other semiconductor light emitting devices according to the first embodiment.

In the semiconductor light emitting device 110f according to the embodiment as illustrated in FIG. 15A, the first electrode 40 includes an n-side electrode 41 and an n-side conductive layer 42. The n-side conductive layer 42 is provided on the surface of the first semiconductor layer 10 on the second major surface 15b side. A portion of the n-side conductive layer 42 is provided between the n-side electrode 41 and the first semiconductor layer 10.

The n-side conductive layer 42 may include any conductive material. The n-side conductive layer 42 can function as a contact electrode for the first semiconductor layer 10.

In particular, a Ag film, an Al film, a Pd film, or a stacked film including at least two selected from a Ag film, an Al film, and a Pd film may be used as the n-side conductive layer 42. Thereby, in particular, a high reflectance with respect to light having a short wavelength (ultraviolet light to blue light) is obtained. Thereby, a high light extraction efficiency is obtained.

The n-side electrode 41 may include, for example, the material of the p-side electrode 51.

In the semiconductor light emitting device 110g according to the embodiment as illustrated in FIG. 15B, the first electrode 40 includes the n-side electrode 41 and the n-side conductive layer 42; and the second electrode 50 includes the p-side electrode 51 and the p-side conductive layer 52. In this example, the n-side conductive layer 42 and the p-side conductive layer 52 include a reflective conductive layer. For example, a Ag film, an Al film, a Pd film, or a stacked film including at least two selected from a Ag film, an Al film, and a Pd film is used as the n-side conductive layer 42 and the p-side conductive layer 52.

The reflective layer 60 is not provided at the portion where the n-side conductive layer 42 and the p-side conductive layer 52 are provided. Because the n-side conductive layer 42 and the p-side conductive layer 52 are reflective in the semiconductor light emitting device 110g, the emitted light Ll is reflected by the n-side conductive layer 42 and the p-side conductive layer 52 and travels toward the first major surface 15a. Therefore, a high light extraction efficiency is obtained even in the case where the reflective layer 60 is not provided at the portion where the n-side conductive layer 42 and the p-side conductive layer 52 are provided.

It is sufficient for the reflective layer 60 to be provided on at least a portion of the side surface of the stacked body 15 other than the portion where the n-side conductive layer 42 and the p-side conductive layer 52 are provided. Thereby, a high light extraction efficiency is obtained.

Thus, at least one selected from the first electrode 40 and the second electrode 50 may include a reflective portion (e.g., the n-side conductive layer 42, the p-side conductive layer 52, or the like) that is reflective with respect to the emitted light. For example, the reflectance of the reflective portion is not less than the reflectance of the reflective layer 60. In such a case, the reflective layer 60 may not be provided on the reflective portion.

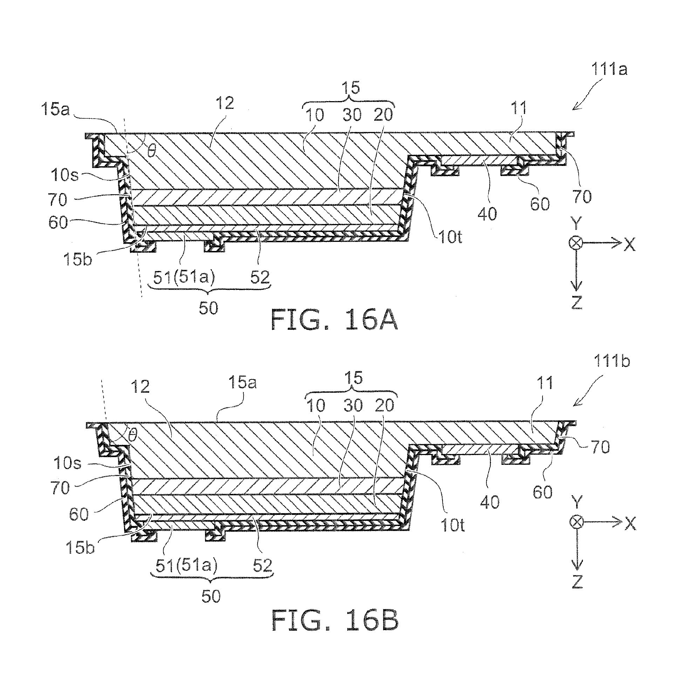

FIG. 16A and FIG. 16B are schematic cross-sectional views illustrating the configurations of other semiconductor light emitting devices according to the first embodiment.

The first metal pillar 45, the second metal pillar 55, and the sealing unit 80 are not illustrated in these drawings.

In the semiconductor light emitting device 111a according to the embodiment as illustrated in FIG. 16A, the side surface of the stacked body 15 is tilted with respect to the Z axis. In other words, for example, the outer edge side surface 10s and the boundary side surface 10t are tilted with respect to the Z-axis direction such that the width of the second semiconductor layer 20 along the X-axis direction (the second direction perpendicular to the first direction) is shorter than the width of the light emitting unit 30 along the X-axis direction. In other words, the side surface of the stacked body 15 has a portion that has a forward-tapered configuration. In this example, the side surface of the outer edge of the first semiconductor layer 10 is substantially parallel to the Z axis.

In the semiconductor light emitting device 111b according to the embodiment as illustrated in FIG. 16B as well, the side surface of the stacked body 15 is tilted with respect to the Z axis. In this example, the side surface of the outer edge of the first semiconductor layer 10 also is tilted with respect to the Z axis. In other words, the side surface of the outer edge of the first semiconductor layer 10 is tilted with respect to the Z-axis direction such that the X-axis direction width of the portion of the side surface of the outer edge of the first semiconductor layer 10 on the first major surface 15a side is larger than the X-axis direction width of the portion of the side surface of the outer edge of the first semiconductor layer 10 on the second major surface 15b side.

Thus, the coverability of the side surface by the foundation insulating layer 70 and the reflective layer 60 is improved by the side surface of the stacked body 15 being tilted (tilted with a forward taper). Thereby, the protection characteristics of the foundation insulating layer 70 are easily improved; and the reflective characteristics of the reflective layer 60 are easily improved.

In the semiconductor light emitting devices 111a and 111b, a taper angle θ of the side surface of the stacked body 15 (the angle between the side surface and the first major surface 15a) is, for example, not less than 45 degrees but less than 90 degrees.

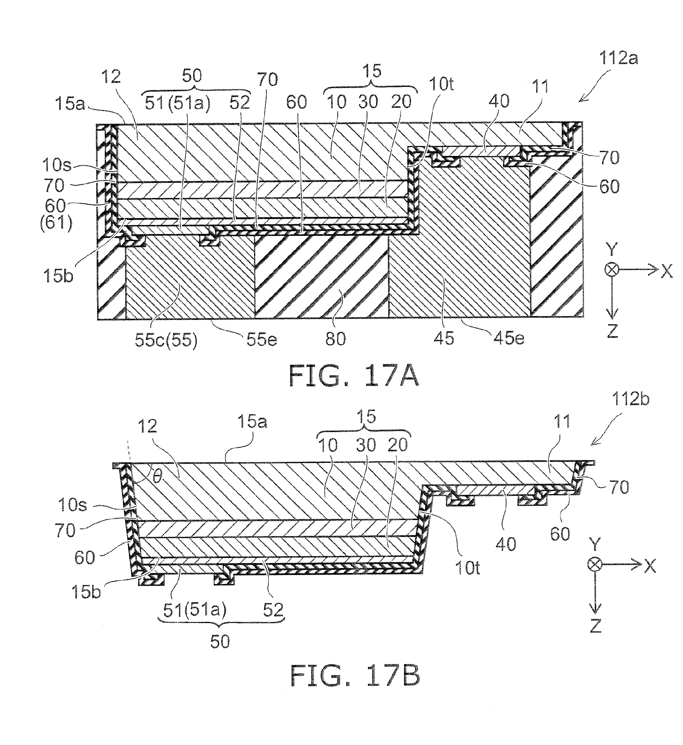

FIG. 17A and FIG. 17B are schematic cross-sectional views illustrating the configurations of other semiconductor light emitting devices according to the first embodiment.

In the semiconductor light emitting device 112a according to the embodiment as illustrated in FIG. 17A, the third portion 13 illustrated in FIG. 2B is not provided in the first semiconductor layer 10.

The first metal pillar 45, the second metal pillar 55, and the sealing unit 80 are not illustrated in FIG. 17B. In the semiconductor light emitting device 112b according to the embodiment as illustrated in FIG. 17B as well, the third portion 13 is not provided. The side surface of the stacked body 15 is tilted with respect to the Z axis.

The wavelength conversion layer 90 may be further provided in the semiconductor light emitting devices 110b to 110g, 110p, 111a, 111b, 112a, and 112b according to the embodiment. As described above, the foundation insulating layer 70 may be provided if necessary and may be omitted from the semiconductor light emitting devices according to the embodiment and the modifications of the semiconductor light emitting devices according to the embodiment.

### Second embodiment

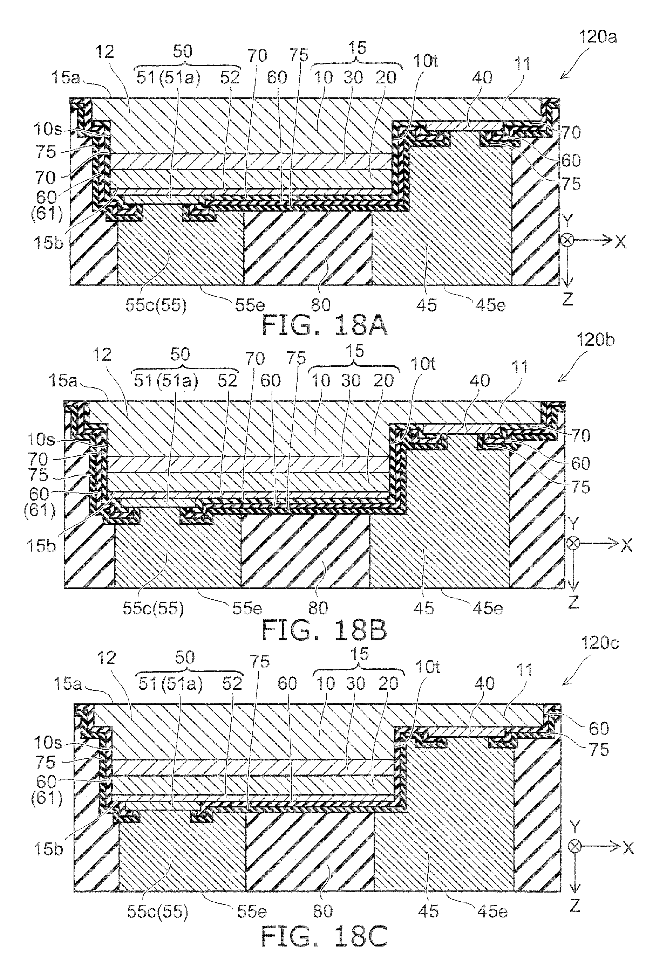

FIG. 18A to FIG. 18C are schematic cross-sectional views illustrating the configurations of semiconductor light emitting devices according to a second embodiment.

As illustrated in FIG. 18A, the semiconductor light emitting device 120a according to the embodiment further includes a covering layer 75. In other words, the semiconductor light emitting device 120a is a device in which the covering layer 75 is further provided in the semiconductor light emitting device 110.

The covering layer 75 covers the reflective layer 60. For example, the covering layer 75 protects the reflective layer 60.

The optical characteristics of the covering layer 75 are arbitrary. For example, the covering layer 75 is transmissive, reflective, or absorptive with respect to the emitted light. In the case where the covering layer 75 is transmissive, the covering layer 75 may include the material described in regard to the foundation insulating layer 70. In the case where the covering layer 75 is reflective, the covering layer 75 may include the material of the reflective layer 60. In the case where the covering layer 75 is absorptive, the covering layer 75 may include the material of the sealing unit 80.

For example, the covering layer 75 includes an organic resin. The covering layer 75 may include, for example, polyimide and the like. However, the embodiment is not limited thereto. The covering layer 75 may include an inorganic material. For example, the covering layer 75 may be insulative. For example, the reliability increases by providing the covering layer 75.

As illustrated in FIG. 18B, the semiconductor light emitting device 120b according to the embodiment is a device in which the covering layer 75 is further provided in the semiconductor light emitting device 110b.

As illustrated in FIG. 18C, the semiconductor light emitting device 120c according to the embodiment is a device in which the covering layer 75 is further provided in the semiconductor light emitting device 110e. The covering layer 75 may be further provided in the semiconductor light emitting devices 110f and 110g.

In the semiconductor light emitting devices 120a to 120c, the reflective layer 60 is exposed at the side surface of the sealing unit 80.

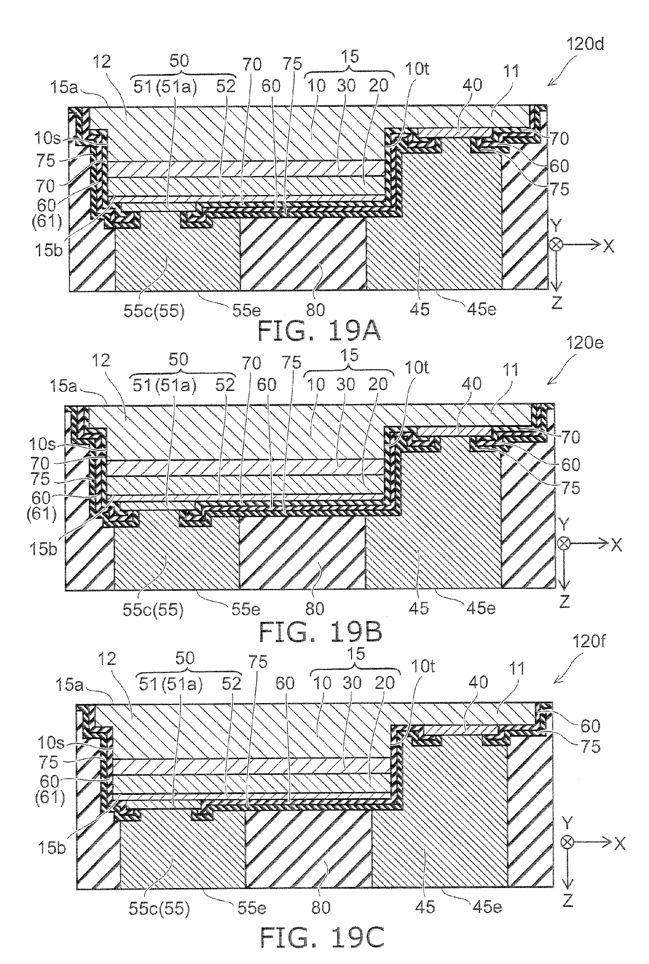

FIG. 19A to FIG. 19C are schematic cross-sectional views illustrating the configurations of other semiconductor light emitting devices according to the second embodiment.

As illustrated in FIG. 19A to FIG. 19C, the covering layer 75 is provided in the semiconductor light emitting devices 120d to 120f as well. The side surface of the reflective layer 60 is covered with the covering layer 75 in these devices. Thus, various modifications are possible.

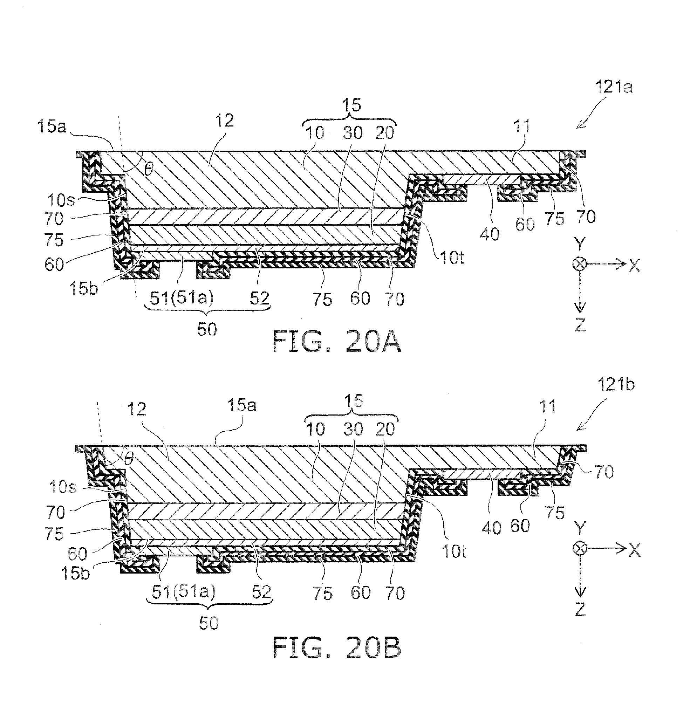

FIG. 20A and FIG. 20B are schematic cross-sectional views illustrating the configurations of other semiconductor light emitting devices according to the second embodiment.

The first metal pillar 45, the second metal pillar 55, and the sealing unit 80 are not illustrated in these drawings.

As illustrated in FIG. 20A, the semiconductor light emitting device 121a according to the embodiment is a device in which the covering layer 75 is further provided in the semiconductor light emitting device 111a.

As illustrated in FIG. 20B, the semiconductor light emitting device 121b according to the embodiment is a device in which the covering layer 75 is further provided in the semiconductor light emitting device 111b.

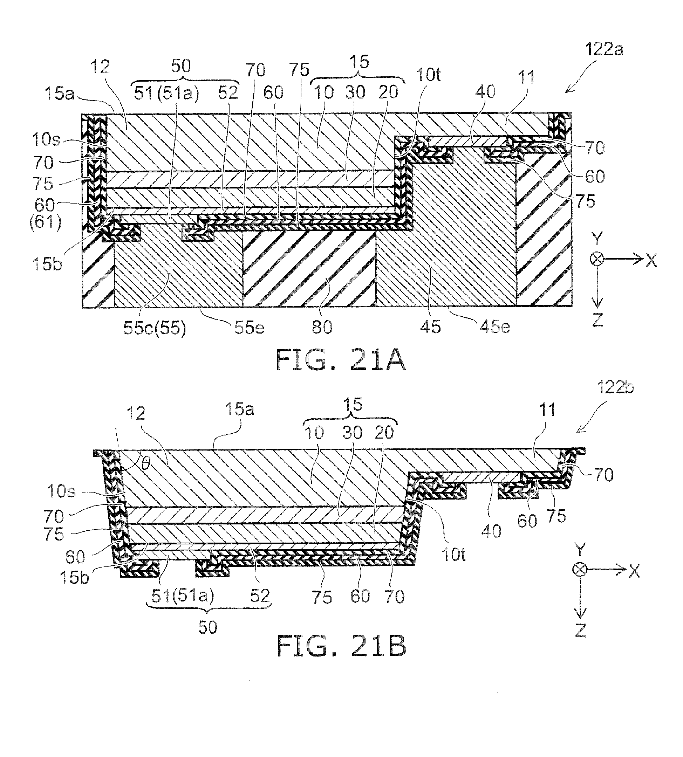

FIG. 21A and FIG. 21B are schematic cross-sectional views illustrating the configurations of other semiconductor light emitting devices according to the second embodiment.

As illustrated in FIG. 21A, the semiconductor light emitting device 122a according to the embodiment is a device in which the covering layer 75 is further provided in the semiconductor light emitting device 112a.

The first metal pillar 45, the second metal pillar 55, and the sealing unit 80 are not illustrated in FIG. 21B. As illustrated in FIG. 21B, the semiconductor light emitting device 122b according to the embodiment is a device in which the covering layer 75 is further provided in the semiconductor light emitting device 112b.

In the configuration in which the covering layer 75 is provided, the foundation insulating layer 70 may be provided if necessary and may be omitted.

According to the embodiment, a semiconductor light emitting device having high efficiency and high reliability can be provided. The wavelength conversion layer 90 may be further provided in the semiconductor light emitting devices 120a to 120f, 121a, 121b, 122a, and 122b according to the embodiment.

For example, the semiconductor light emitting device according to the embodiment can be utilized as a light source such as an illumination apparatus, a display apparatus, etc.

According to the embodiment, a semiconductor light emitting device having high efficiency is provided.

In the specification, "nitride semiconductor" includes all compositions of semiconductors of the chemical formula BₓIn_{y}Al_{z}Ga_{1-x-y-z}N (0 ≤ x ≤ 1, 0 ≤ y ≤ 1, 0 ≤ z ≤ 1, and x+y+z ≤ 1) for which the compositional proportions x, y, and z are changed within the ranges respectively. "Nitride semiconductor" further includes group V elements other than N (nitrogen) in the chemical formula recited above, various elements added to control various properties such as the conductivity type and the like, and various elements included unintentionally.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in semiconductor light emitting devices such as semiconductor layers, light emitting units, stacked bodies, electrodes, metal pillars, sealing units, foundation insulating layers, reflective layers, covering layers, wavelength conversion layers, and the like from known art; and such practice is included in the scope of the invention to the extent that similar effects are obtained.

Further, any two or more components of the specific examples may be combined within the extent of technical feasibility and are included in the scope of the invention to the extent that the purport of the invention is included.

Moreover, all semiconductor light emitting devices practicable by an appropriate design modification by one skilled in the art based on the semiconductor light emitting devices described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A semiconductor light emitting device (110, 110a-110g, 110p, 111a, 111b, 112a, 112b, 120a-120f, 121a, 121b, 122a, 112b), comprising:
a stacked body (15) including
a first semiconductor layer (10) of a first conductivity type having a first portion (11) and a second portion (12) juxtaposed with the first portion (11),
a second semiconductor layer (20) of a second conductivity type, and
a light emitting unit (30) provided between the second portion (12) and the second semiconductor layer (20),
the stacked body (15) having a first major surface (15a) on a side of the first semiconductor layer (10) and a second major surface (15b) on a side of the second semiconductor layer (20);
a first electrode (40) provided on a surface of the first portion (11) on a side of the second major surface (15b);
a second electrode (50) provided on a surface of the second semiconductor layer (20) on a side of the second major surface (15b);
a reflective layer (60) covering a side surface of the stacked body (15), the reflective layer (60) being insulative and reflective with respect to an emitted light emitted from the light emitting unit (30);
a first metal pillar (45) extending in a first direction from the first semiconductor layer (10) toward the second semiconductor layer (20), the first metal pillar (45) being electrically connected to the first electrode (40);
a second metal pillar (55) extending in the first direction, the second metal pillar (55) being electrically connected to the second electrode (50); and
a sealing unit (80) sealing the first metal pillar (45) and the second metal pillar (55) to leave an end portion (45e) of the first metal pillar (45) and an end portion (55e) of the second metal pillar (55) exposed.

2. The device (110, 110a-110g, 110p, 111a, 111b, 112a, 112b, 120a-120f, 121a, 121b, 122a, 112b) according to claim 1, wherein a reflectance of the reflective layer (60) with respect to the emitted light is not less than a reflectance of the sealing unit (80) with respect to the emitted light.

3. The device (110, 110a-110g, 110p, 111a, 111b, 112a, 112b, 120a-120f, 121a, 121b, 122a, 112b) according to any of claims 1 and 2, wherein the sealing unit (80) is reflective with respect to the emitted light.

4. The device (110, 110a-110g, 110p, 111a, 111b, 112a, 112b, 120a-120f, 121a, 121b, 122a, 112b) according to any of claims 1-3, wherein the sealing unit (80) includes an insulative resin.

5. The device (110, 110a-110g, 110p, 111a, 111b, 112a, 112b, 120a-120f, 121a, 121b, 122a, 112b) according to claim 4, wherein the sealing unit (80) includes at least one selected from the group consisting of ZnO, TiO₂, ZrO₂, Al₂O₃, MgO, CaTiO₂, BaSO₄, ZnS and CaCO₃.

6. The device (110, 110a-110g, 110p, 111a, 111b, 112a, 112b, 120a-120f, 121a, 121b, 122a, 112b) according to any of claims 1-5, wherein
the stacked body (15) has an outer edge side surface (10s) of an outer edge when viewed in the first direction, and a boundary side surface (10t) positioned between the first portion (11) and the second portion (12), and
the reflective layer (60) covers at least a portion of the outer edge side surface (10s) and at least a portion of the boundary side surface (10t).

7. The device (110, 110a-110g, 110p, 111a, 111b, 112a, 112b, 120a-120f, 121a, 121b, 122a, 112b) according to any of claims 1-6, wherein the reflective layer (60) has a portion between the first electrode (40) and the first metal pillar (45).

8. The device (110, 110a-110g, 110p, 111a, 111b, 112a, 112b, 120a-120f, 121a, 121b, 122a, 112b) according to claim 7, wherein the reflective layer (60) further has a portion between the second electrode (50) and the second metal pillar (55).

9. The device (110, 110a-110g, 110p, 111a, 111b, 112a, 112b, 120a-120f, 121a, 121b, 122a, 112b) according to any of claims 1-8, wherein
an area of the first metal pillar (45) when viewed in the first direction is larger than an area of the first electrode (40), and
an area of the second metal pillar (55) when viewed in the first direction is larger than an area of the second electrode (50).

10. The device (110, 110a-110g, 110p, 111a, 111b, 112a, 112b, 120a-120f, 121a, 121b, 122a, 112b)according to any of claims 1-9, wherein the reflective layer (60) includes at least one selected from the group consisting of zinc oxide (ZnO), titanium dioxide (TiO₂) zirconium oxide (ZrO₂), aluminum oxide Al₂O₃), magnesium oxide (MgO), calcium titanate (CaTiO₂) barium sulfate (BaSO₄), zinc sulfide (ZnS), and calcium carbonate (CaCO₃).

11. The device (110, 110a-110g, 110p, 111a, 111b, 112a, 112b, 120a-120f, 121a, 121b, 122a, 112b) according to any of claims 1-10, wherein the reflective layer (60) includes a plurality of first dielectric layers (61a) and a plurality of second dielectric layers (61b), the first dielectric layers (61a) and the second dielectric layers (61b) are alternately stacked and the first dielectric layers (61a) and the second dielectric layers (61b) have mutually different refractive indexes.

12. The device (110, 110a-110f, 110p, 111a, 111b, 112a, 112b, 120a-120f, 121a, 121b, 122a, 112b) according to any of claims 1-11, wherein
the reflective layer (60) covers an edge portion of the first electrode (40), a side surface of the first electrode (40), an edge portion of the second electrode (50), and a side surface of the second electrode (50),
the first metal pillar (45) covers a portion of the reflective layer (60), and
the second metal pillar (55) covers a portion of the reflective layer (60).

13. The device (110, 110a-110g, 110p, 111a, 111b, 112a, 112b, 120a-120f, 121a, 121b, 122a, 112b) according to any claims 1-12, wherein the sealing unit (80) covers at least a portion of the reflective layer (60).

14. The device (110, 110a-110c, 110f, 110g, 110p, 111a, 111b, 112a, 112b, 120a-120f, 121a, 121b, 122a, 112b) according to any of claims 1-13, further comprising a foundation insulating layer (70),
at least a portion of the foundation insulating layer (70) being provided between the reflective layer (60) and at least a portion of an outer edge side surface (10s) of an outer edge of the stacked body (15) when viewed in the first direction and between the reflective layer (60) and at least a portion of a boundary side surface (10t) of the stacked body (15) positioned between the first portion (11) and the second portion (12), and
a reflectance of the foundation insulating layer (70) with respect to the emitted light being lower than a reflectance of the reflective layer (60) with respect to the emitted light.

15. The device (110, 110a-110c, 110f, 110p, 111a, 111b, 112a, 112b, 120a-120f, 121a, 121b, 122a, 112b) according to claim 14, wherein
the foundation insulating layer (70) covers a portion of the first electrode (40) and a portion of the second electrode (50), and
the reflective layer (60) covers a portion of the foundation insulating layer (70) covering the portion of the first electrode (40) and covers a portion of the foundation insulating layer (70) covering the portion of the second electrode (50).

16. The device (110, 110a-110c, 110f, 110p, 111a, 111b, 112a, 112b, 120a-120f, 121a, 121b, 122a, 112b) according to claim 14, wherein the reflective layer (60) covers a side surface of the foundation insulating layer (70).

17. The device (110, 110a-110g, 110p, 111a, 111b, 112a, 112b, 120a-120f, 121a, 121b, 122a, 112b) according to any of claims 1-16, wherein the foundation insulating layer (70) includes at least one of silicon oxide and silicon nitride.

18. The device (110, 110a-110g, 110p, 111a, 111b, 112a, 112b, 120a-120f, 121a, 121b, 122a, 112b) according to any of claims 1-16, wherein the foundation insulating layer (70) includes at least one of polyimide, polybenzoxazole (PBO), and a silicone material.

19. The device (120a-120f, 121a, 121b, 122a, 112b) according to claim 1, further comprising a covering layer (75) covering the reflective layer (60).

20. The device (120a-120f, 121a, 121b, 122a, 112b) according to claim 19, wherein the covering layer (75) is insulative.
